# EUROPEAN PATENT APPLICATION

(11) **EP 1 770 441 A2**
(43) Date of publication of application: **04.04.2007**
(21) Application number: 06020577.0
(22) Date of filing: 29.09.2006
(51) Int. Cl.: G03F 7/039

(54) **Positive resist composition and pattern forming method using the same**

(30) Priority: 29.09.2005 JP 2005285022
(71) Applicant: FUJIFILM Corporation, Minato-ku Tokyo (JP)
(72) Inventor: Mizutani, Kazuyoshi, c/o Fuji Photo Co., Ltd., Haibara-gun, Shizuoka (JP)
(74) Representative: HOFFMANN EITLE

(57) **Abstract**

A positive resist composition including: (A-1) a resin of which a solubility in an alkali developer increases under the action of an acid, the resin including a repeating unit represented by formula (Ia) and a repeating unit represented by formula (A1); and (B) a compound capable of generating an acid upon irradiation with one of actinic ray and radiation: 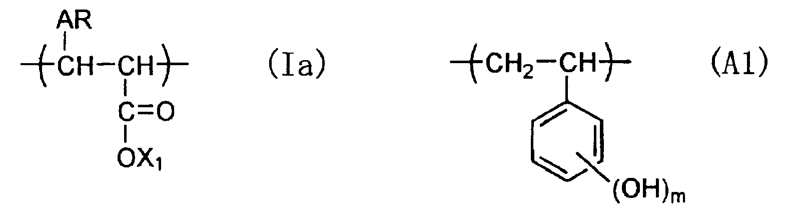 wherein
in the formula (Ia), AR represents an aromatic group, and X₁ represents a group having a carbon number of 5 or more and being capable of decomposing under the action of an acid, and in the formula (A1), m represents an integer of one of 1 and 2.

## Description

### Background of the Invention

### 1. Field of the Invention

The present invention relates to a positive resist composition suitably used in the ultramicrolithography process or other photofabrication processes for the production or the like of VLSI or a high-capacity microchip. More specifically, the present invention relates to a positive resist composition capable of forming a highly refined pattern with use of KrF excimer laser light, electron beam, EUV light or the like, that is, the present invention relates to a positive resist composition suitably usable for fine processing of a semiconductor device, where KrF excimer laser light, electron beam or extreme ultraviolet light is used, and a pattern forming method using the composition.

### 2. Background Art

In the process of producing a semiconductor device such as IC and LSI, fine processing by lithography using a photoresist composition has been conventionally performed. Recently, the integration degree of an integrated circuit is increased and along with this trend, formation of an ultrafine pattern in the sub-micron or quarter-micron region is required. To meet this requirement, the exposure wavelength also tends to become shorter, for example, from g line to i line or further to KrF excimer laser light. At present, other than the excimer laser light, development of lithography using electron beam, X ray or extreme ultraviolet (EUV) is proceeding.

The lithography using electron beam or EUV light is positioned as a next-generation or next-next-generation pattern formation technique and a positive resist with high sensitivity and high resolution is being demanded. In particular, the elevation of sensitivity for shortening the wafer processing time is very important but in the positive resist for use with electron beam or EUV, when higher sensitivity is sought for, not only reduction in the resolving power but also worsening of the defocus latitude depended on line pitch are brought about and development of a resist satisfying these properties at the same time is strongly demanded. The defocus latitude depended on line pitch as used herein means a difference in the pattern dimension between a high density portion and a low density portion of a resist pattern and when this difference is large, the process margin at the actual pattern formation is disadvantageously narrowed. How to reduce this difference is one of important problems to be solved in the resist technology development. The high sensitivity is in a trade-off relationship with high resolution, good pattern profile and good defocus latitude depended on line pitch and it is very important how to satisfy these properties at the same time.

Furthermore, also in the lithography using KrF excimer laser light, how to satisfy all of high sensitivity, high resolution, good pattern profile and good defocus latitude depended on line pitch is an important problem, and this problem needs to be solved.

As for the resist suitable for such a lithography process using KrF excimer laser light, electron beam or EUV light, a chemical amplification-type resist utilizing an acid catalytic reaction is mainly used from the standpoint of elevating the sensitivity and in the case of a positive resist, a chemical amplification-type resist composition mainly comprising an acid generator and a phenolic polymer which is insoluble or sparingly soluble in an alkali developer but becomes soluble in an alkali developer under the action of an acid (hereinafter simply referred to as a "phenolic acid-decomposable resin"), is being effectively used.

With respect to such a positive resist, there are known some resist compositions using a phenolic acid-decomposable resin obtained by copolymerizing an acid-decomposable acrylate monomer having an alicyclic group as the acid-decomposable group. Examples thereof include the positive resist compositions disclosed in U.S. Patent 5,561,194, JP-A-2001-166474 (the term "JP-A" as used herein means an "unexamined published Japanese patent application"), JP-A-2001-166478, JP-A-2003-107708 and JP-A-2001-194792.

In U.S. Patent 6,312,870, a resist comprising a resin containing a repeating unit derived from a cinnamic acid ester is disclosed with an attempt to improve the pattern profile and the etching resistance.

However, by any combination of these techniques, it is impossible at present to satisfy all of high sensitivity, high resolution, good pattern profile and good defocus latitude depended on line pitch, in the ultrafine region.

### Summary of the Invention

An object of the present invention is to solve the problems in the technology for enhancing the performance at the fine processing of a semiconductor device using actinic rays or radiation, particularly, KrF excimer laser light, electron beam or EUV light, and provide a positive resist composition capable of satisfying all of high sensitivity, high resolution, good pattern profile and good defocus latitude depended on line pitch and also assured of good dissolution contrast, and a pattern forming method using the composition.

The present inventors have made intensive studies, as a result, surprisingly, the object of the present invention can be attained by a positive resist composition comprising a resin using a blend of specific phenolic acid-decomposable resins differing in the structure, and a pattern forming method using the composition.

That is, the object of the present invention is attained by the following constitutions.
(1) A positive resist composition comprising:
   (A-1) a resin of which a solubility in an alkali developer increases under the action of an acid, the resin comprising a repeating unit represented by formula (Ia) and a repeating unit represented by formula (A1); and
   (B) a compound capable of generating an acid upon irradiation with one of actinic rays and radiation: 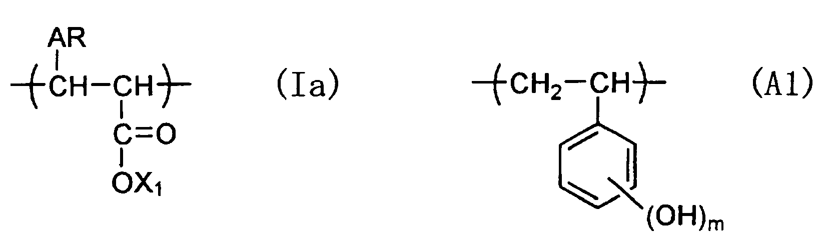 wherein
      in the formula (Ia), AR represents an aromatic group, and X₁ represents a group having a carbon number of 5 or more and being capable of decomposing under the action of an acid, and
      in the formula (A1), m represents an integer of one of 1 and 2.
(2) The positive resist composition as described in the item (1), wherein X₁ has a tertiary carbon atom bonded to the oxygen atom in formula (Ia).
(3) The positive resist composition as described in the item (1), wherein X₁ has an alicyclic group.
(4) A positive resist composition comprising:
   (A-2) a resin of which a solubility in an alkali developer increases under the action of an acid, the resin comprising a repeating unit represented by formula (Ib) and a repeating unit represented by formula (A2); and
   (B) a compound capable of generating an acid upon irradiation with one of actinic rays and radiation: 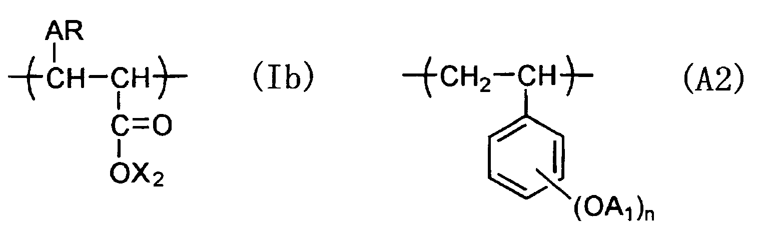 wherein
      in the formula (Ib), AR represents an aromatic group and X₂ represents one of a hydrogen atom and a hydrocarbon group, and
      in the formula (A2), A₁ represents a group containing a group capable of decomposing under the action of the acid, and n represents an integer of one of 1 and 2.
(5) The positive resist composition as described in the item (4) above, wherein X₂ is a group capable of decomposing under the action of the acid.
(6) The positive resist composition as described in the item (5), wherein X₂ is a group having an alicyclic group and being capable of decomposing under the action of the acid.
(7) A pattern forming method comprising:
   forming a resist film from a positive resist composition as described in the item (1); and
   exposing and developing the resist film.
(8) The pattern forming method as described in the item (7),
   wherein the resist film is exposed with one of electron beam and extreme ultraviolet light.
(9) A pattern forming method comprising:
   forming a resist film from a positive resist composition as described in the item (4); and
   exposing and developing the resist film.
(10) The pattern forming method as described in the item (9),
wherein the resist film is exposed with one of electron beam and extreme ultraviolet light.

According to the present invention, as regards the pattern formation by the irradiation of electron beam, KrF excimer laser light, EUV light or the like, a positive resist composition excellent in the sensitivity and resolving power and further excellent in the pattern profile, defocus latitude depended on line pitch, and dissolution contrast, and a pattern forming method using the composition can be provided.

### Detailed Description of the Invention

The compounds for use in the present invention are described in detail below.

Incidentally, in the present invention, when a group (atomic group) is denoted without specifying whether substituted or unsubstituted, the group includes both a group having no substituent and a group having a substituent. For example, an "alkyl group" includes not only an alkyl group having no substituent (unsubstituted alkyl group) but also an alkyl group having a substituent (substituted alkyl group).

### [1] Resins (A-1) and (A-2) which are insoluble or sparingly soluble in an alkali developer and of which solubility in an alkali developer increases under the action of an acid

The resin of which solubility in an alkali developer increases under the action of an acid, contained in the positive resist composition of the present invention, is at least either a resin (A-1) comprising a repeating unit represented by formula (Ia) and a repeating unit represented by formula (A1), or a resin (A-2) comprising a repeating unit represented by formula (Ib) and a repeating unit represented by formula (A2).

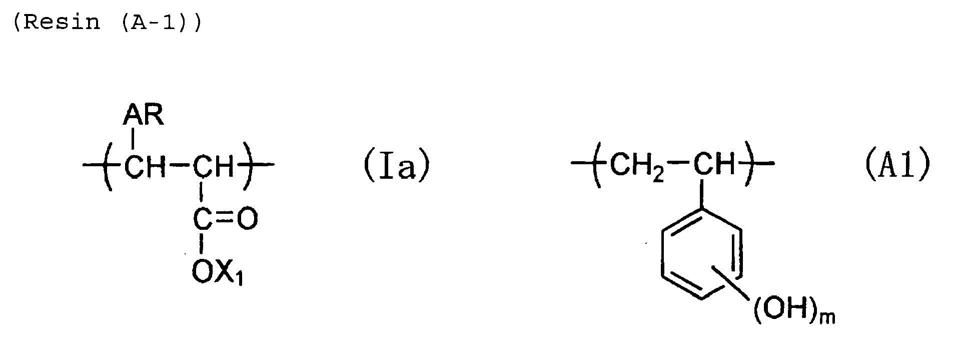

In formula (Ia), AR represents an aromatic group, preferably a phenyl group (a hydroxyphenyl group as a phenyl group having a substituent), a naphthyl group or an anthranyl group.

The aromatic group as AR may have a substituent, and examples of the substituent include a hydroxyl group, an alkoxy group, an acyl group, an acyloxy group, an alkyl group, a cyano group, an aryloxy group, an aralkyl group, an aryl group, a nitro group and a halogen atom. As for the alkoxy group, acyl group, acyloxy group, alkyl group, aryloxy group, aralkyl group and aryl group, the carbon number is 12 or less, preferably 6 or less.

X₁ represents a group having a carbon number of 5 or more and being capable of decomposing under the action of an acid (acid-decomposable group).

More specifically, this is a group such that X₁ splits off under the action of an acid and the oxygen atom in formula (Ia) forms a hydroxyl group, for example, a group where the atom bonded to the oxygen atom in formula (Ia) is a tertiary carbon atom.

Examples of the group of X₁ having a carbon number of 5 or more and being capable of decomposing under the action of an acid include a tertiary alkyl group such as tert-amyl group, an isoboronyl group, a 1-alkoxyethyl group such as 1-butoxyethyl group, 1-isobutoxyethyl group and 1-cyclohexyloxyethyl group, an alkoxymethyl group, a tetrahydropyranyl group, a tetrahydrofuranyl group, a 3-oxocyclohexyl ester group, a 2-methyl-2-adamantyl group and a mevalonic lactone residue. This acid-decomposable group preferably has a carbon number of 6 to 15 and preferably has an alicyclic structure.

The alicyclic structure may be either monocyclic or polycyclic. Specific examples thereof include monocyclo, bicyclo, tricyclco and tetracyclo structures having a carbon number of 5 or more. The carbon number thereof is preferably 6 to 30, more preferably from 7 to 25. Such an alicyclic ring may have a substituent.

Specific examples of the alicyclic structure are set forth below.

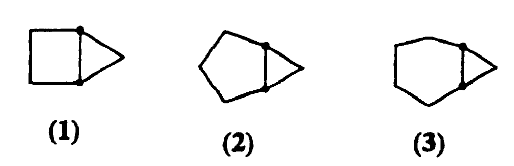

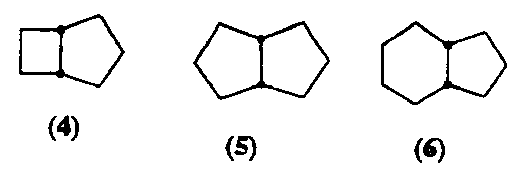

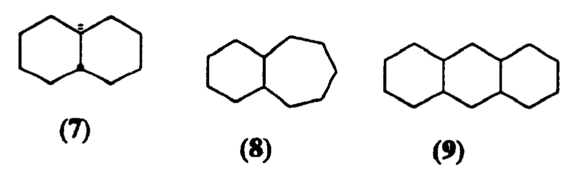

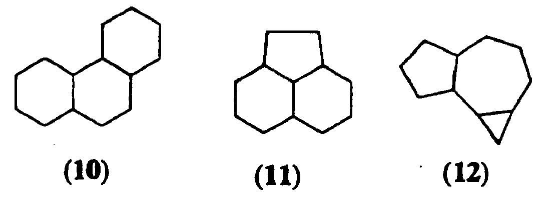

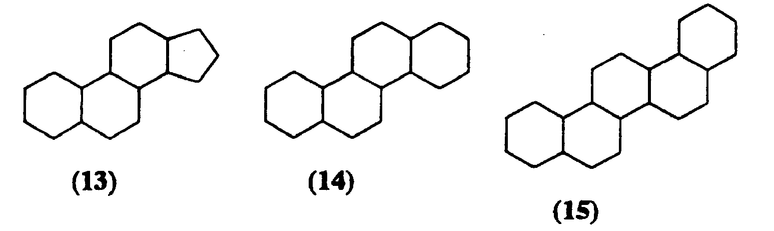

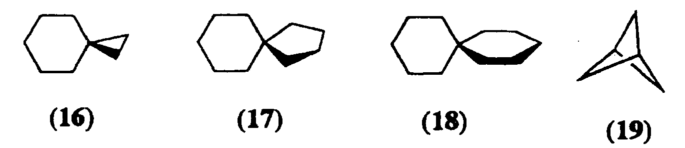

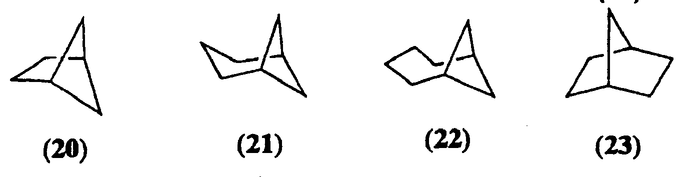

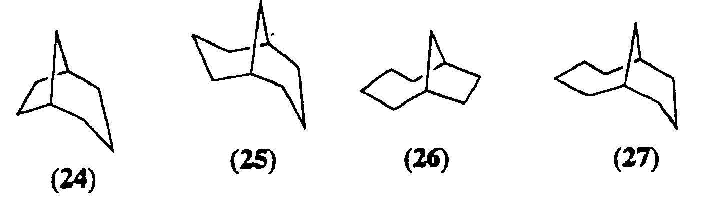

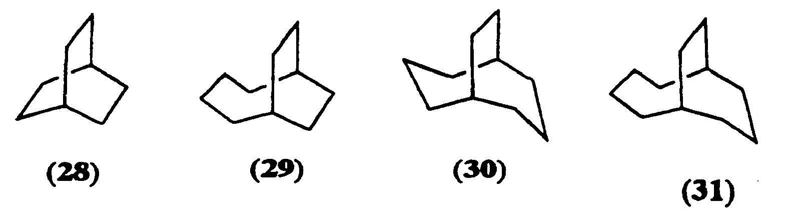

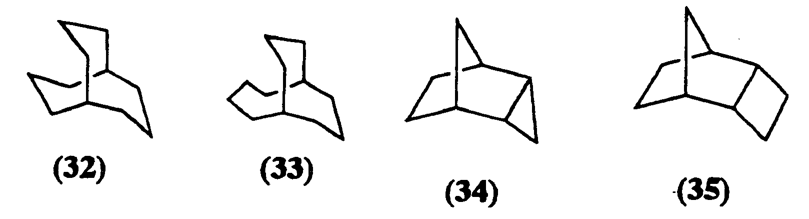

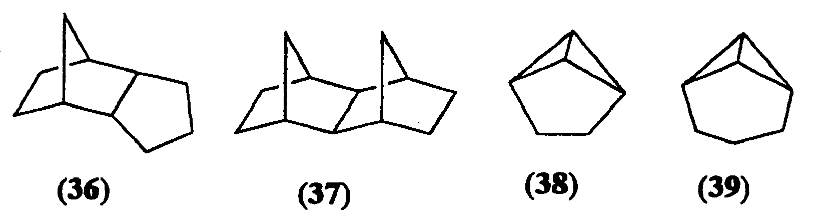

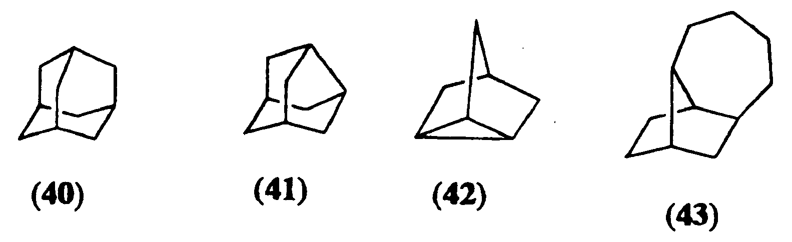

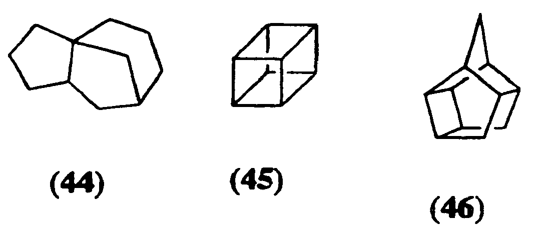

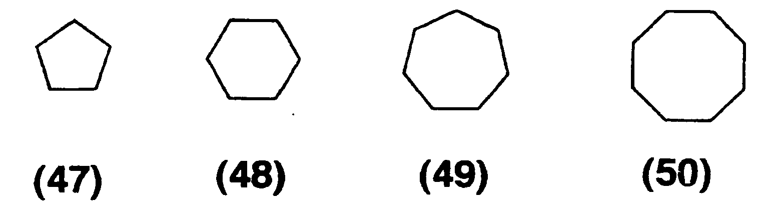

In the present invention, among these alicyclic structures, preferred are, as denoted in terms of the monovalent alicyclic group, an adamantyl group, a noradamantyl group, a decalin residue, a tricyclodecanyl group, a tetracyclododecanyl group, a norbornyl group, a cedrol group, a cyclohexyl group, a cycloheptyl group, a cyclooctyl group, a cyclodecanyl group and a cyclododecanyl group, more preferred are an adamantyl group, a decalin residue, a norbornyl group, a cedrol group, a cyclohexyl group, a cycloheptyl group, a cyclooctyl group, a cyclodecanyl group and a cyclododecanyl group.

Examples of the substituent which the alicyclic ring in these structures may have include an alkyl group, a halogen atom, a hydroxyl group, an alkoxy group, a carboxyl group and an alkoxycarbonyl group. The alkyl group is preferably a lower alkyl group such as methyl group, ethyl group, propyl group, isopropyl group and butyl group, more preferably a methyl group, an ethyl group, a propyl group or an isopropyl group. The alkoxy group includes an alkoxy group having a carbon number of 1 to 4, such as methoxy group, ethoxy group, propoxy group and butoxy group. The alkyl group and the alkoxy group each may further have a substituent, and examples of the substituent which the alkyl group and the alkoxy group may further have include a hydroxyl group, a halogen atom and an alkoxy group.

The acid-decomposable group having an alicyclic structure is preferably a group represented by any one of the following formulae (pI) to (pV): 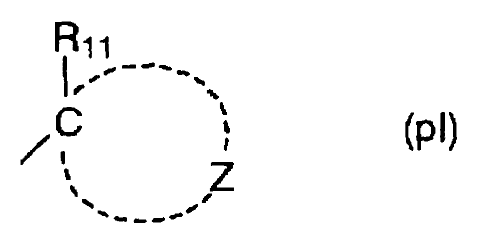 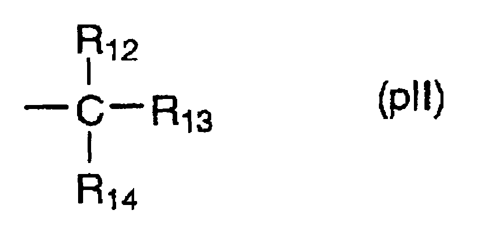 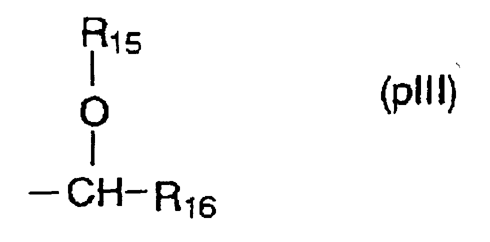 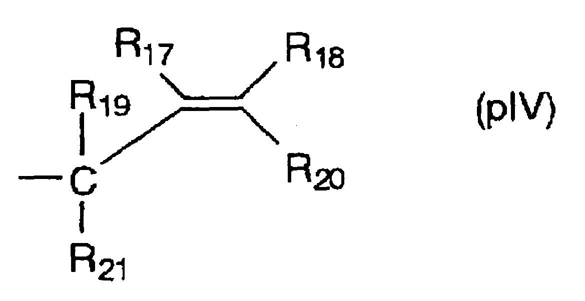 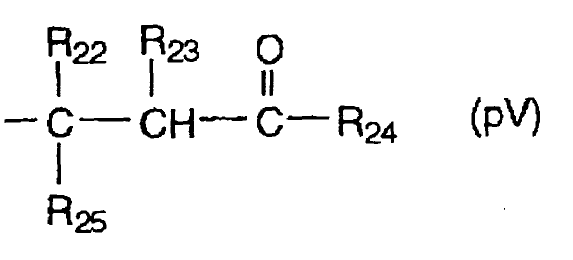 wherein R₁₁ represents a methyl group, an ethyl group, an n-propyl group, an isopropyl group, an n-butyl group, an isobutyl group or a sec-butyl group,

Z represents an atomic group necessary for forming an alicyclic hydrocarbon group together with the carbon atom,

R₁₂ to R₁₆ each independently represents a linear or branched alkyl group having a carbon number of 1 to 4 or an alicyclic hydrocarbon group, provided that at least one of R₁₂ to R₁₄ or either one of R₁₅ and R₁₆ represents an alicyclic hydrocarbon group,

R₁₇ to R₂₁ each independently represents a hydrogen atom, a linear or branched alkyl group having a carbon number of 1 to 4 or an alicyclic hydrocarbon group, provided that at least one of R₁₇ to R₂₁ represents an alicyclic hydrocarbon group and that either one of R₁₉ and R₂₁ represents a linear or branched alkyl group having a carbon number of 1 to 4 or an alicyclic hydrocarbon group,

R₂₂ to R₂₅ each independently represents a hydrogen atom, a linear or branched alkyl group having a carbon number of 1 to 4 or an alicyclic hydrocarbon group, provided that at least one of R₂₂ to R₂₅ represents an alicyclic hydrocarbon group, and

R₂₃ and R₂₄ may combine with each other to form a ring.

In formulae (pI) to (pV), the alkyl group of R₁₂ to R₂₅ is a linear or branched alkyl group having from 1 to 4 carbon atoms, which may be substituted or unsubstituted, and examples of the alkyl group include a methyl group, an ethyl group, an n-propyl group, an isopropyl group, an n-butyl group, an isobutyl group, a sec-butyl group and a tert-butyl group.

Examples of the substituent which the alkyl group may further have include an alkoxy group having a carbon number of 1 to 4, a halogen atom (e.g., fluorine, chlorine, bromine, iodine), an acyl group, an acyloxy group, a cyano group, a hydroxyl group, a carboxy group, an alkoxycarbonyl group and a nitro group.

Examples of the alicyclic hydrocarbon group of R₁₁ to R₂₅ and the alicyclic hydrocarbon group formed by Z together with the carbon atom include those described above for the alicyclic structure.

Specific examples of the alicyclic structure-containing hydrocarbon group as X₁ are set forth below.

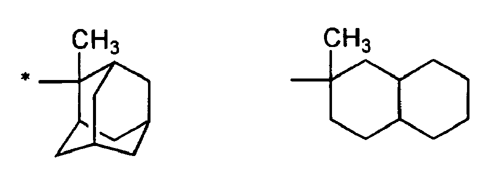

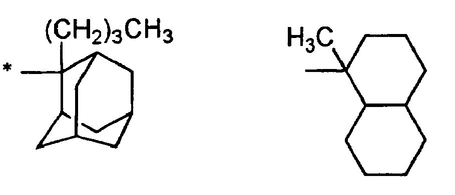

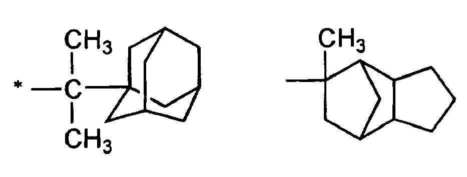

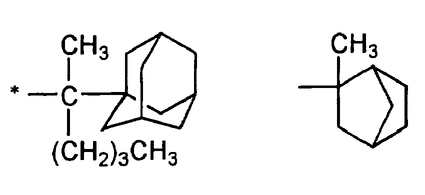

In formula (A1), m represents an integer of 1 to 2.

In formula (A1), the substitution site of -OH is preferably p-position, m-position or a mixture of p-position and m-position.

Other examples of the substituent which the benzene ring in formula (A1) may have include an alkyl group, a halogen atom, a carboxyl group, an alkoxy group, an acyl group, an acyloxy group, an aryloxy group, an aralkyl group, an aryl group, a cyano group and a nitro group. The carbon number thereof is preferably 10 or less.

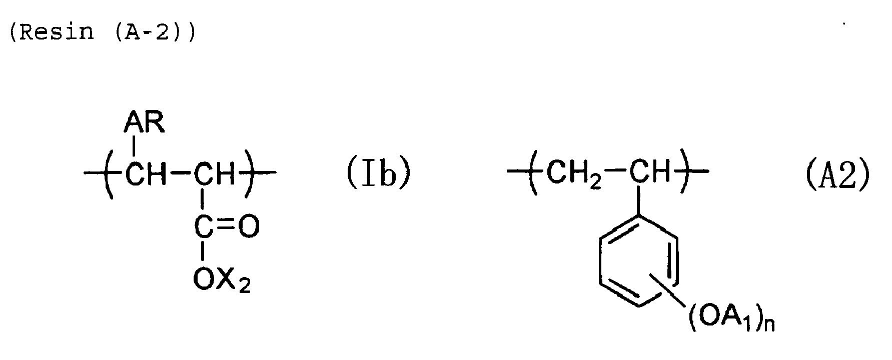

In formula (Ib), AR has the same definition as AR in formula (Ia) .

X₂ represents a hydrogen atom or a hydrocarbon group (preferably having a carbon number of 20 or less, more preferably from 6 to 12), preferably an alicyclic structure-containing hydrocarbon group (for example, an alicyclic group itself or an alkyl group substituted by an alicyclic group).

Examples of the alicyclic structure are the same as those of X₁ in formula (Ia).

In particular, the hydrocarbon group as X₂ is preferably an acid-decomposable group. The details of the acid-decomposable group as X₂ are the same as those of the acid-decomposable group as X₁.

In formula (A2), n represents an integer of 1 to 2. A₁ represents a group containing a group capable of decomposing under the action of an acid. When a plurality of A₁s are present, these may be the same or different.

The group as A₁ containing a group capable of decomposing under the action of an acid may be a group of producing a hydroxyl group in the benzene ring in formula (A2) as a result of elimination of A₁, that is, an acid-decomposable group itself, or an acid-decomposable group-containing group, that is, a group of decomposing under the action of an acid to produce an alkali-soluble group such as hydroxyl group and carboxyl group, in the residue bonded to the repeating unit.

The substitution site of -OA₁ in formula (A2) is preferably p-position, m-position or a mixture of p-position and m-position.

Other examples of the substituent which the benzene ring in formula (A2) may have include an alkyl group, a halogen atom, a carboxyl group, an alkoxy group, an acyl group, an acyloxy group, an aryloxy group, an aralkyl group, an aryl group, a cyano group and a nitro group. The carbon number thereof is preferably 10 or less.

Specific examples of the repeating units represented by formulae (Ia) and (Ib) are set forth below, but the present invention is not limited thereto.

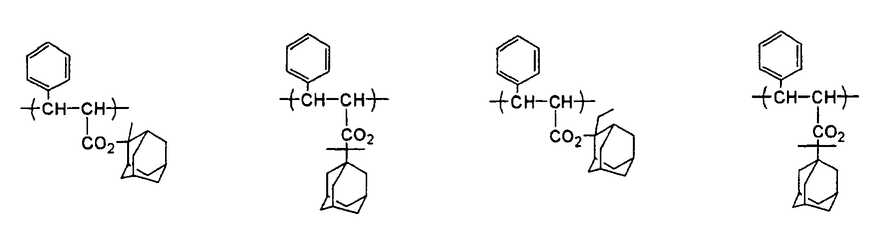

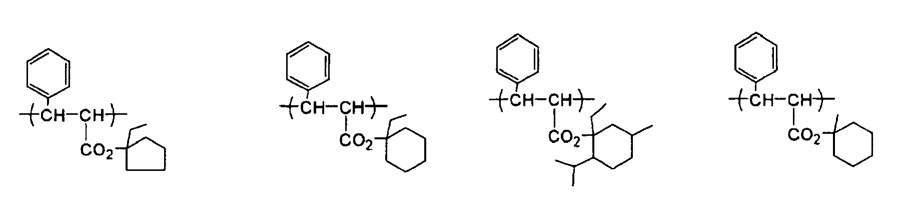

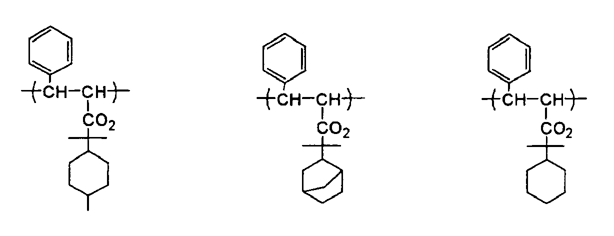

The monomer corresponding to the repeating unit represented by formula (Ia) or (Ib) may be synthesized by esterifying cinnamic acid chloride and an alcohol compound in a solvent such as THF, acetone and methylene chloride, in the presence of a basic catalyst such as triethylamine, pyridine and DBU. A commercially available product may also be used.

Specific examples of the repeating unit represented by formula (A1) are set forth below, but the present invention is not limited thereto.

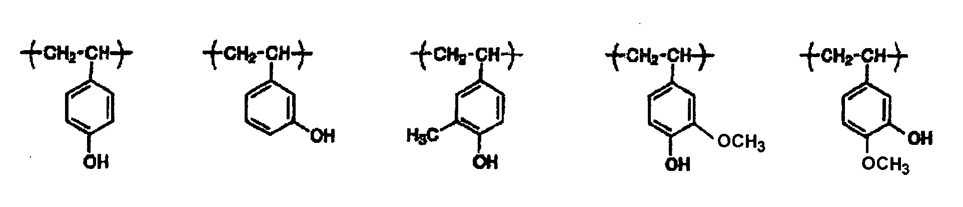

Specific examples of the repeating unit represented by formula (A2) are set forth below, but the present invention is not limited thereto.

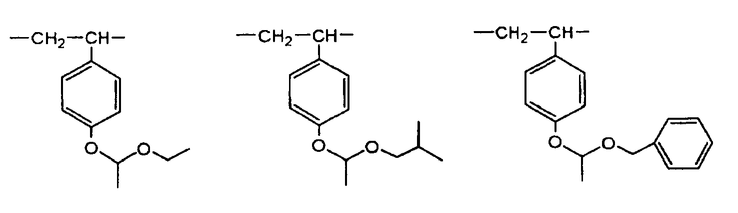

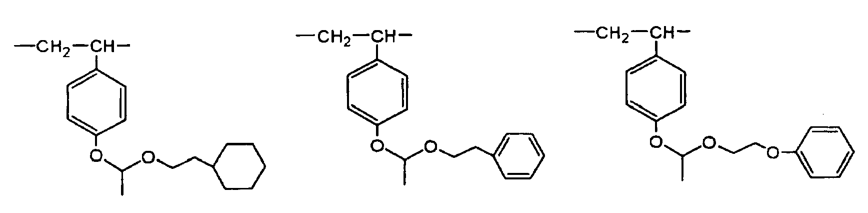

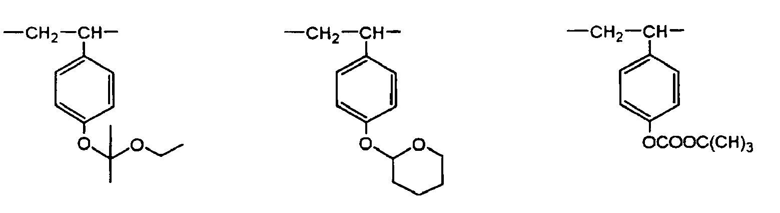

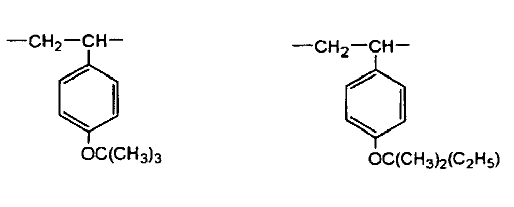

The resin (A) preferably further contains a repeating unit represented by formula (A4). 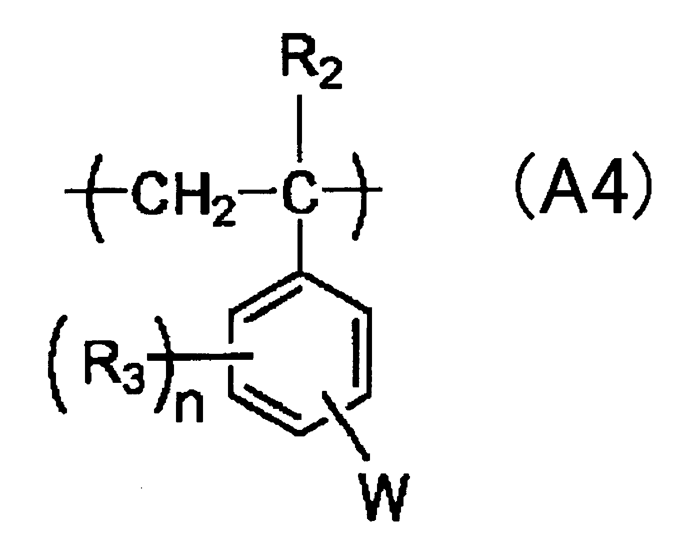 wherein R₂ represents a hydrogen atom, a methyl group, a cyano group, a halogen atom or a perfluoro group having a carbon number of 1 to 4,

R₃ represents a hydrogen atom, an alkyl group, a halogen atom, an aryl group, an alkoxy group or an acyl group,

n represents an integer of 0 to 4, and

W represents a group incapable of decomposing under the action of an acid.

W represents a group incapable of decomposing under the action of an acid (sometimes referred to as an "acid-stable group"), and specific examples thereof include a hydrogen atom, a halogen atom, an alkyl group, a cycloalkyl group, an alkenyl group, an aryl group, an acyl group, an alkylamido group, an arylamidomethyl group and an arylamido group. The acid stable group is preferably an acyl group or an alkylamido group, more preferably an acyl group, an alkylcarbonyloxy group, an alkyloxy group, a cycloalkyloxy group or an aryloxy group.

In the acid-stable group represented by W, the alkyl group is preferably an alkyl group having a carbon number of 1 to 4, such as methyl group, ethyl group, propyl group, n-butyl group, sec-butyl group and tert-butyl group; the cycloalkyl group is preferably a cycloalkyl group having a carbon number of 3 to 10, such as cyclopropyl group, cyclobutyl group, cyclohexyl group and adamantyl group; the alkenyl group is preferably an alkenyl group having a carbon number of 2 to 4, such as vinyl group, propenyl group, allyl group and butenyl group; the alkenyl group is preferably an alkenyl group having a carbon number of 2 to 4, such as vinyl group, propenyl group, allyl group and butenyl group; and the aryl group is preferably an aryl group having a carbon number of 6 to 14, such as phenyl group, xylyl group, toluyl group, cumenyl group, naphthyl group and anthracenyl group. W may be present at any position on the benzene ring but is preferably present at the meta-position or para-position, more preferably at the para-position, of the styrene skeleton.

Specific examples of the repeating unit represented by formula (A4) are set forth below, but the present invention is not limited thereto.

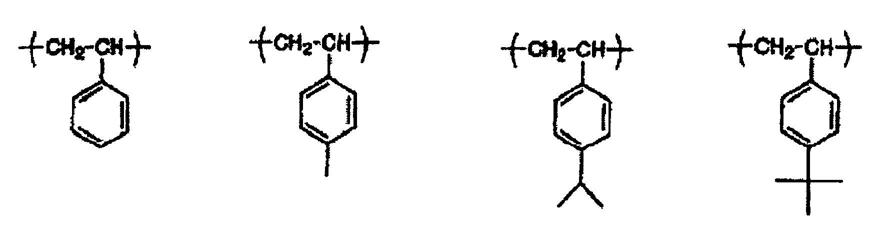

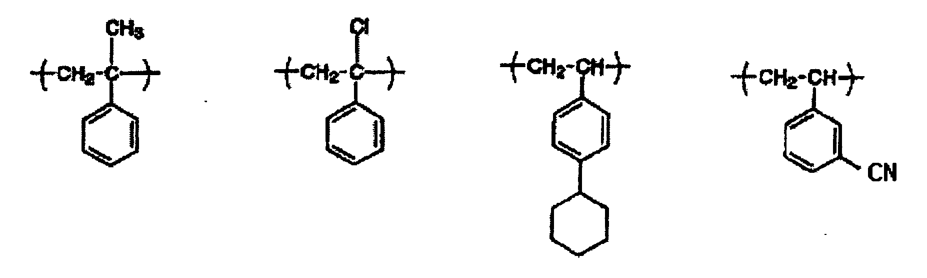

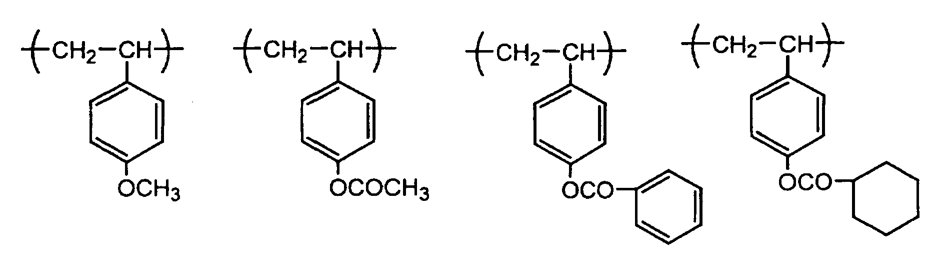

The resin (A-1) or (A-2) is a resin of which solubility in an alkali developer increases under the action of an acid (acid-decomposable resin), and contains a group capable of decomposing under the action of an acid to produce an alkali-soluble group (acid-decomposable group), in an arbitrary repeating unit.

As described above, the acid-decomposable group may be contained in the repeating unit represented by formula (Ia), (Ib) or (A2) or in other repeating unit.

Examples of the acid-decomposable group include, in addition to those described above, a group represented by -C(=O)-X₁-R₀.

In the formula above, R₀ represents, for example, a tertiary alkyl group such as tert-butyl group and tert-amyl group, a 1-alkoxyethyl group such as isobornyl group, 1-ethoxyethyl group, 1-butoxyethyl group, 1-isobutoxyethyl group and 1-cyclohexyloxyethyl group, an alkoxymethyl group such as 1-methoxymethyl group and 1-ethoxymethyl group, a 3-oxoalkyl group, a tetrahydropyranyl group, a tetrahydrofuranyl group, a trialkylsilyl ester group, a 3-oxocyclohexyl ester group, a 2-methyl-2-adamantyl group or a mevalonic lactone group. X₁ represents an oxygen atom, a sulfur atom, -NH-, -NHSO₂- or -NHSO₂NH-.

The content of the repeating unit represented by formula (Ia) or (Ib) in the resin (A-1) or (A-2) is preferably from 10 to 60 mol%, more preferably from 15 to 50 mol%, still more preferably from 20 to 40 mol%, based on all repeating units.

The content of the repeating unit represented by formula (A1) in the resin (A-1) is preferably from 40 to 90 mol%, more preferably from 50 to 85 mol%, still more preferably from 55 to 80 mol%, based on all repeating units.

The content of the repeating unit represented by formula (A2) in the resin (A-2) is preferably from 5 to 60 mol%, more preferably from 10 to 50 mol%, still more preferably from 20 to 40 mol%, based on all repeating units.

The resins (A-1) and (A-2) each may further contain a repeating unit represented by formula (4), and this is preferred from the standpoint of, for example, enhancing the film quality or suppressing the film loss in the unexposed area. The content of the repeating unit represented by formula (4) is preferably from 0 to 50 mol%, more preferably from 0 to 40 mol%, still more preferably from 0 to 30 mol%, based on all repeating units in each resin.

Also, in each of the resins (A-1) and (A-2), other appropriate polymerizable monomer may be copolymerized to introduce an alkali-soluble group such as phenolic hydroxyl group or carboxyl group for maintaining good developability with an alkali developer, or other hydrophobic polymerizable monomer such as alkyl acrylate or alkyl methacrylate may be copolymerized for enhancing the film quality.

The weight average molecular weight (Mw) of each of the resins (A-1) and (A-2) is preferably from 1,000 to 15, 000, more preferably from 3,000 to 10,000. The dispersity (Mw/Mn) is preferably from 1.0 to 2.0, more preferably from 1.0 to 1.8, still more preferably from 1.0 to 1.5.

The weight average molecular weight here is defined as a polystyrene-reduced value determined by gel permeation chromatography.

The resins (A-1) and (A-2) each may be used in combination of two or more thereof.

The amount of the resin (A-1) or (A-2) added is, as the total amount, usually from 10 to 96 mass%, preferably from 15 to 96 mass%, more preferably from 20 to 95 mass%, based on the entire solid content of the positive resist composition.

Specific examples of the resins (A-1) and (A-2) are set forth below, but the present invention is not limited thereto.

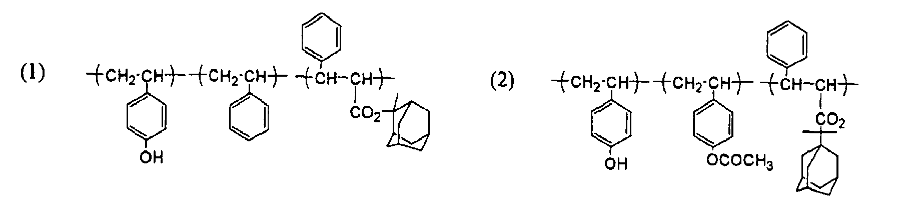

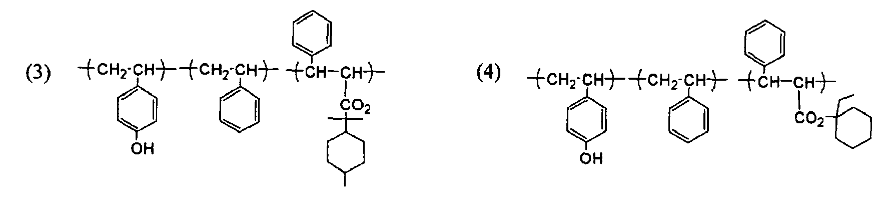

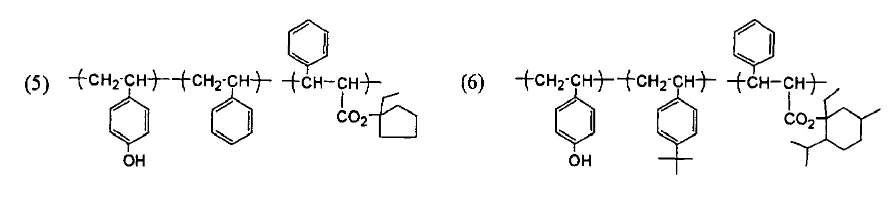

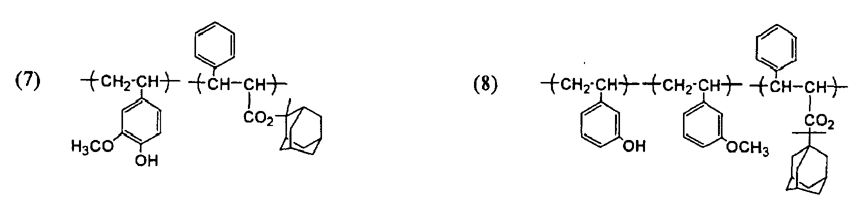

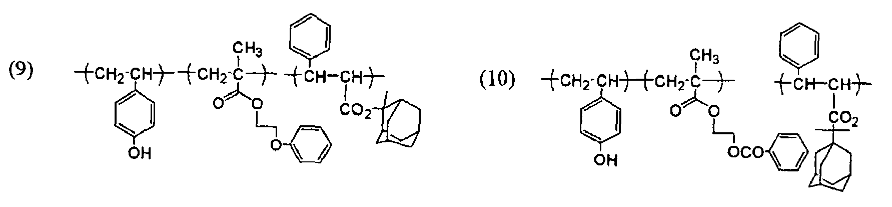

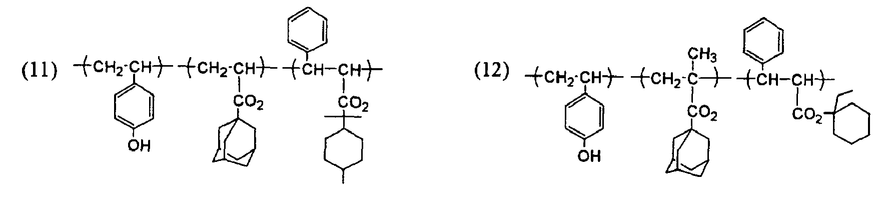

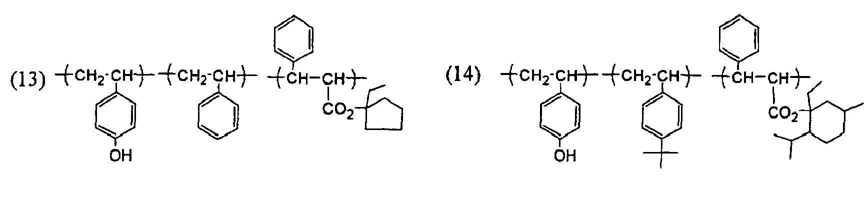

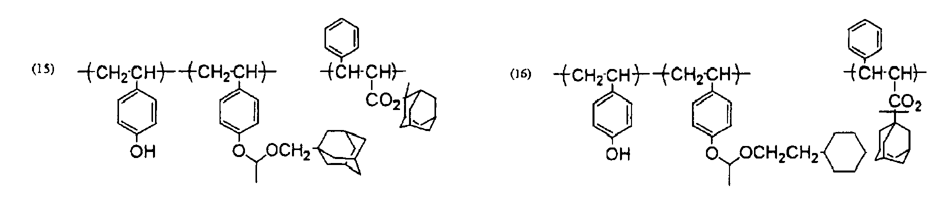

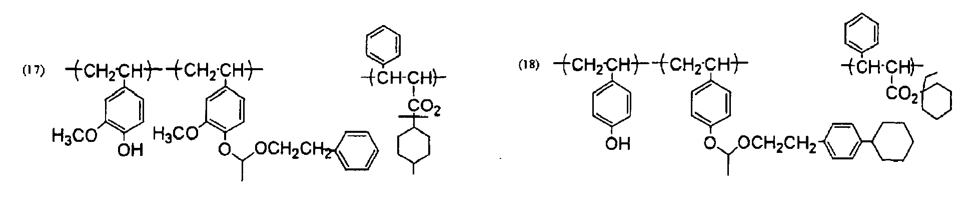

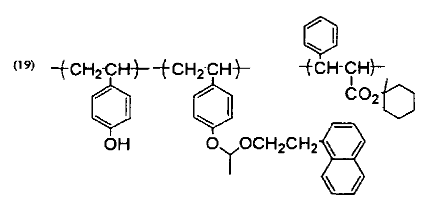

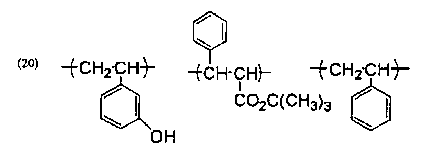

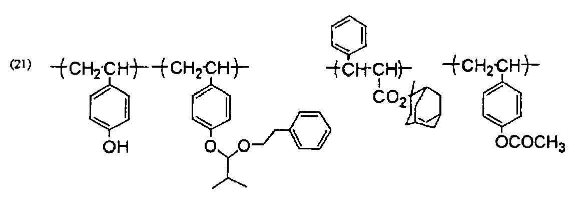

### [2] Compound capable of generating acid upon irradiation with actinic rays or radiation

In the resist composition of the present invention, a known compound may be used as the compound capable of generating an acid upon irradiation with actinic rays or radiation (acid generator), but a compound capable of generating a sulfonic acid upon irradiation with actinic rays or radiation (sulfonic acid generator) and/or a compound capable of generating a carboxylic acid upon irradiation with actinic rays or radiation (carboxylic acid generator) are preferably contained.

### (Compound (B) capable of generating sulfonic acid upon irradiation with actinic rays or radiation)

The compound capable of generating a sulfonic acid upon irradiation with actinic rays or radiation (sometimes referred to as a "compound (B) or a "sulfonic acid generator") is a compound capable of generating a sulfonic acid upon irradiation with actinic rays or radiation such as KrF excimer laser, electron beam and EUV, and examples thereof include a diazonium salt, a phosphonium salt, a sulfonium salt, an iodonium salt, an imidosulfonate, an oxime sulfonate, a diazodisulfone, a disulfone and an o-nitrobenzylsulfonate.

Also, a compound where such a group or compound capable of generating an acid upon irradiation with actinic rays or radiation is introduced into the main or side chain of a polymer may be used, and examples thereof include the compounds described in U.S. Patent 3,849,137, German Patent 3,914,407, JP-A-63-26653, JP-A-55-164824, JP-A-62-69263, JP-A-63-146038, JP-A-63-163452, JP-A-62-153853 and JP-A-63-146029.

Furthermore, compounds capable of generating an acid by the effect of light described, for example, in U.S. Patent 3,779,778 and European Patent 126,712 may also be used.

In the present invention, from the standpoint of enhancing the image performance such as resolving power and pattern profile, a sulfonium salt, an iodonium salt, an imidosulfonate, an oxime sulfonate, a diazodisulfone and a disulfone are preferred as the sulfonic acid generator.

Particularly preferred examples of these compounds set forth below.

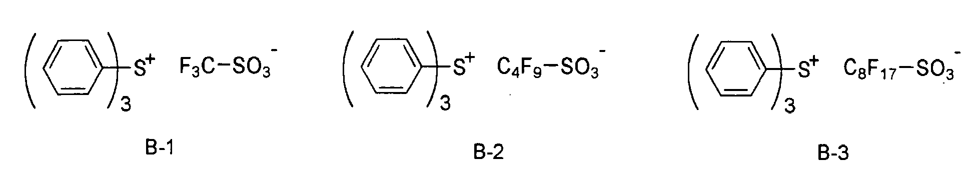

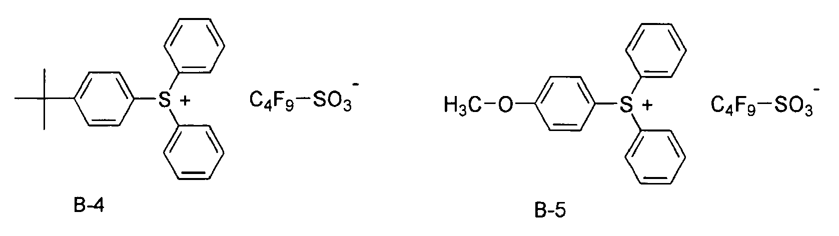

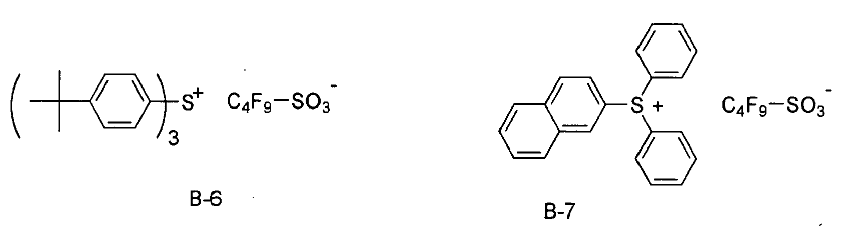

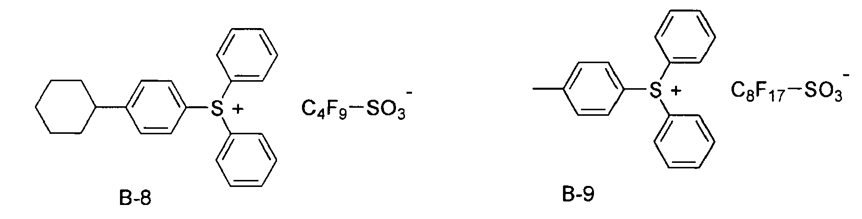

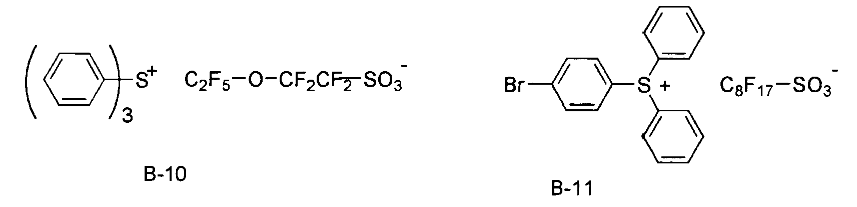

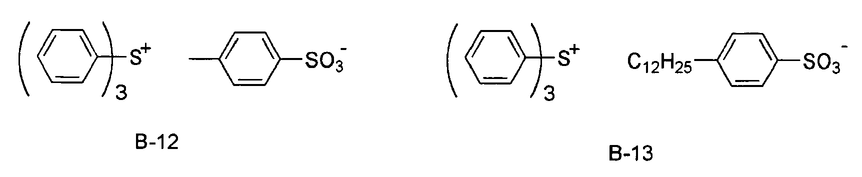

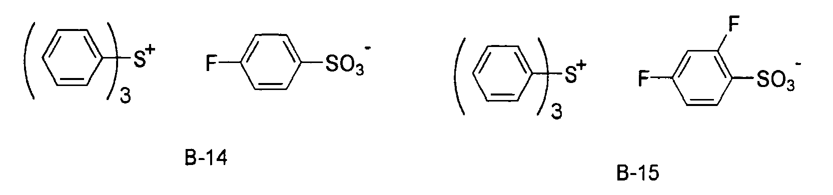

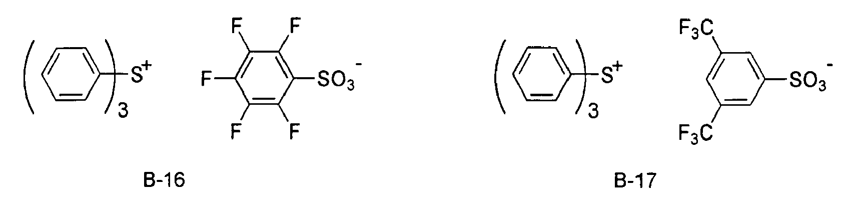

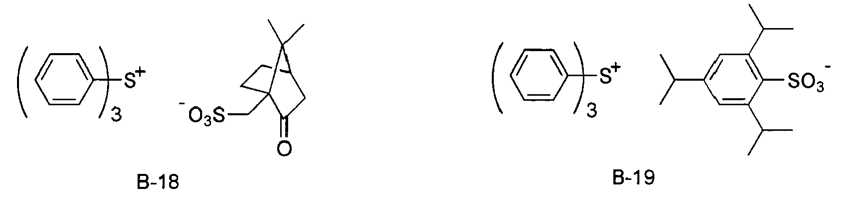

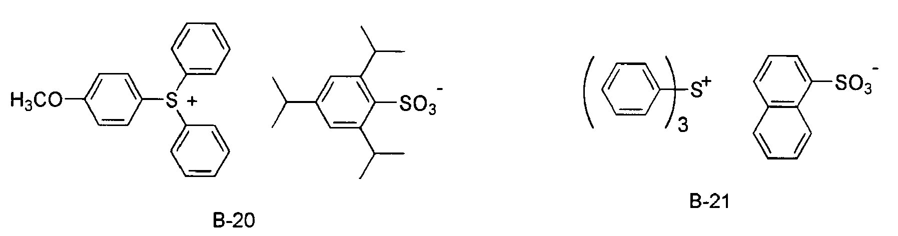

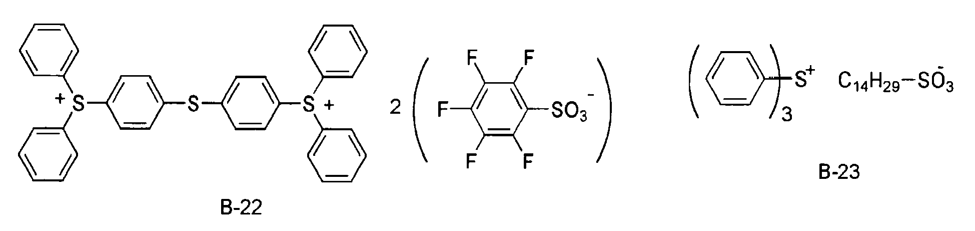

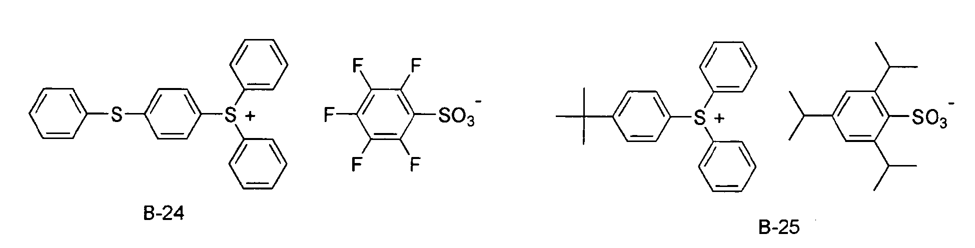

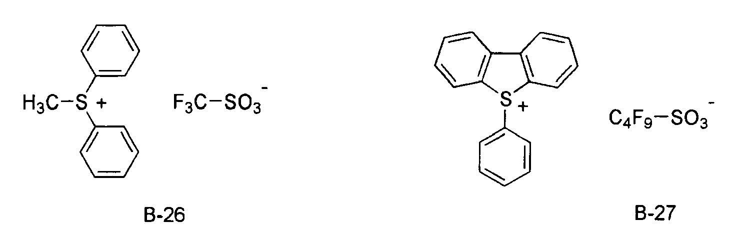

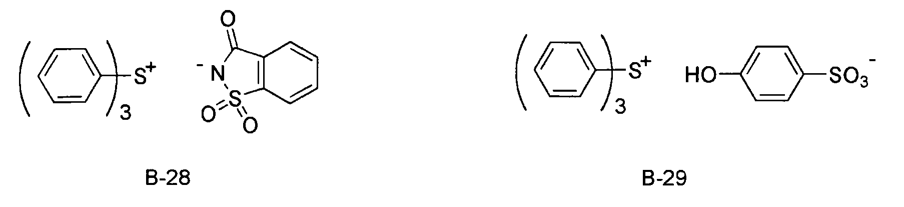

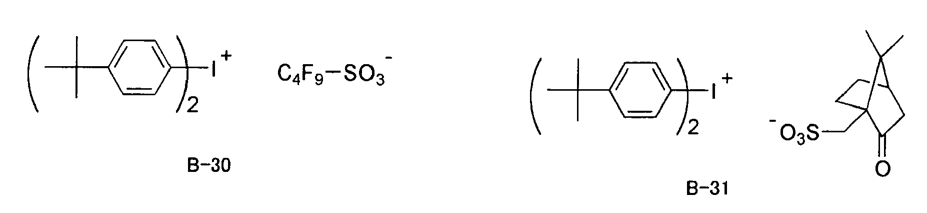

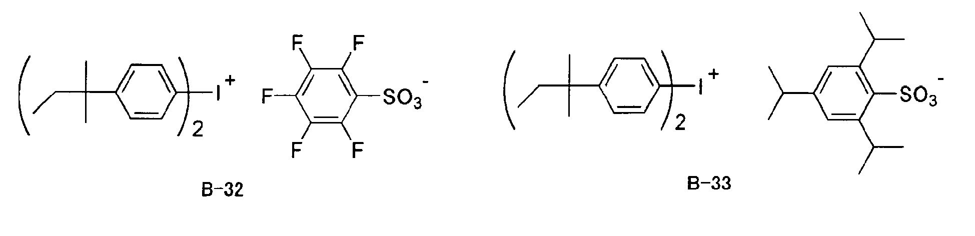

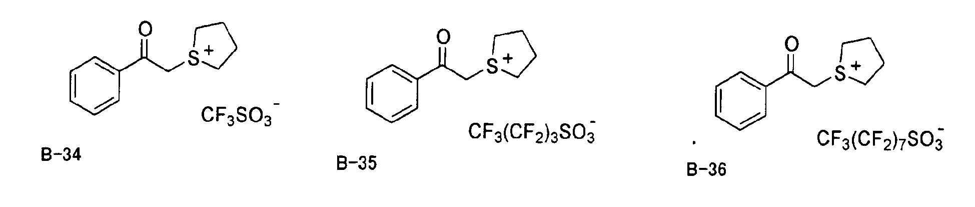

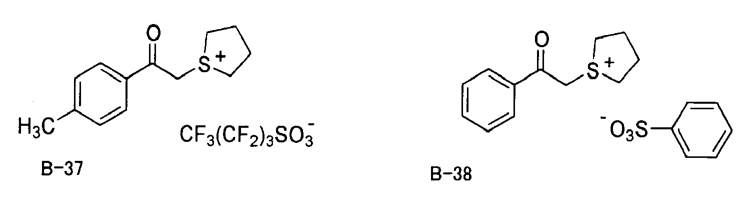

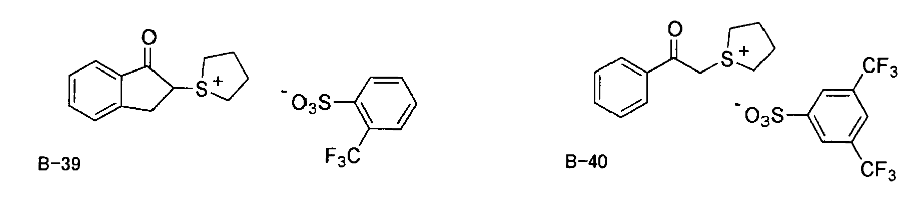

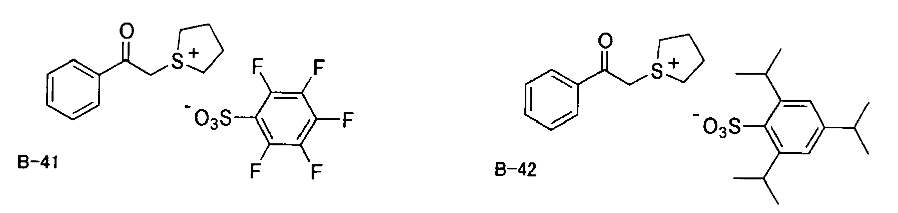

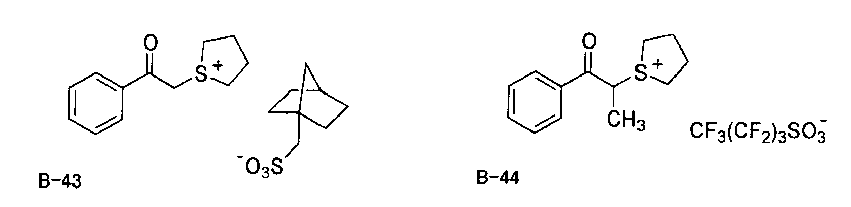

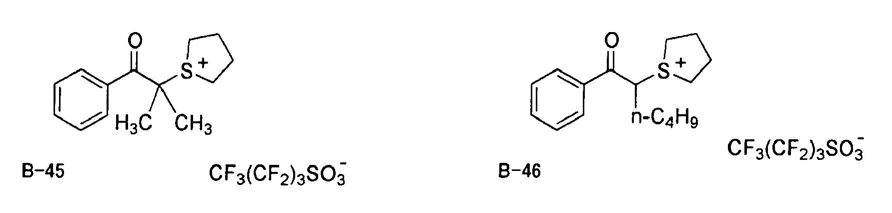

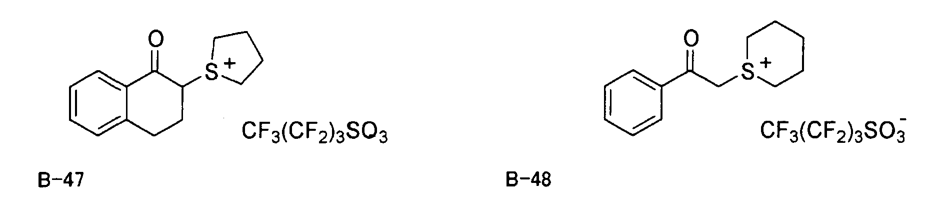

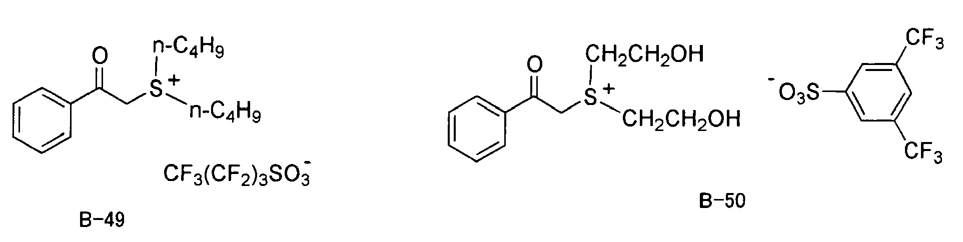

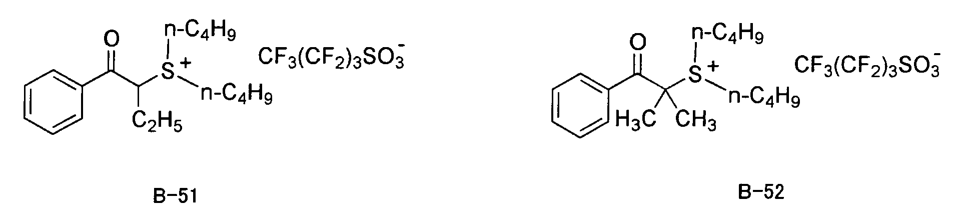

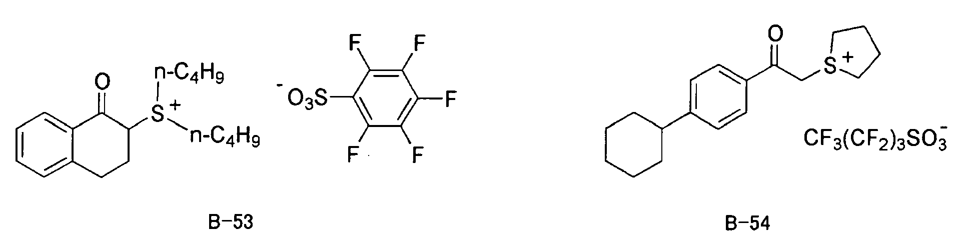

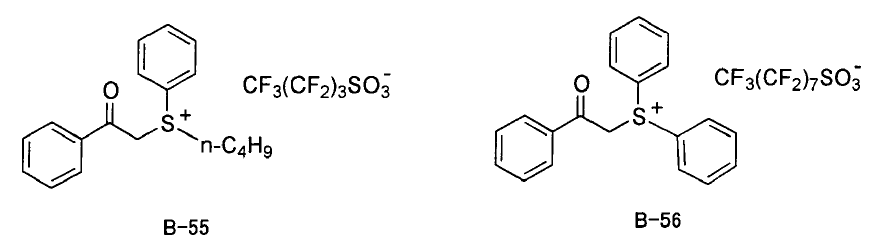

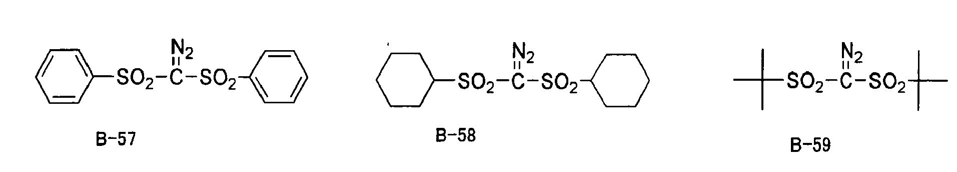

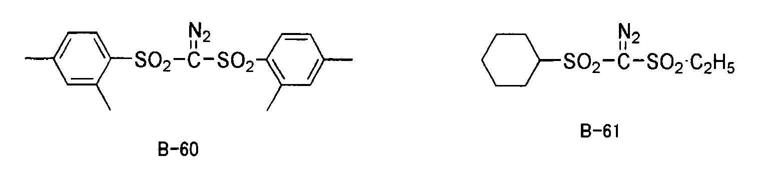

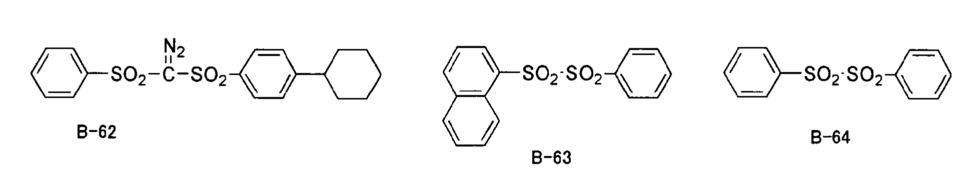

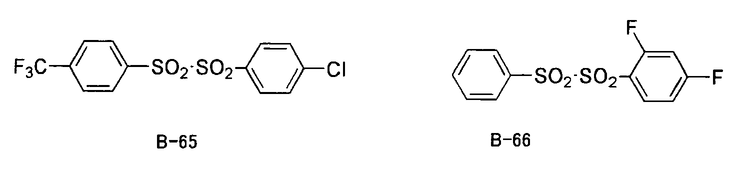

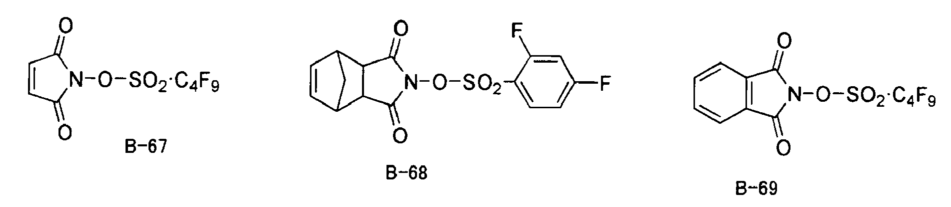

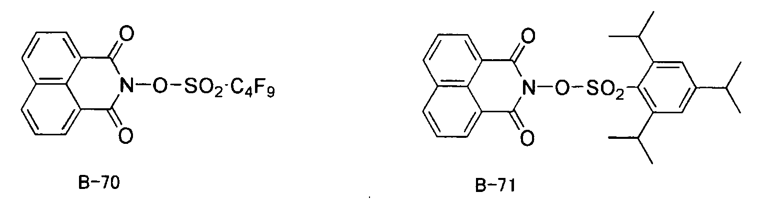

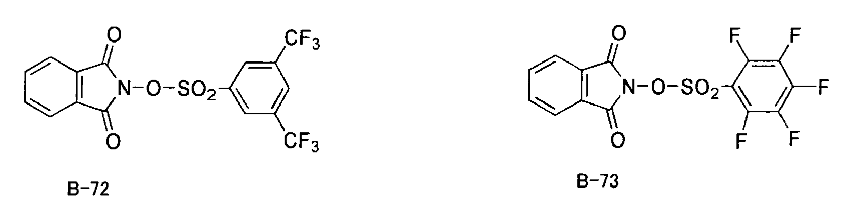

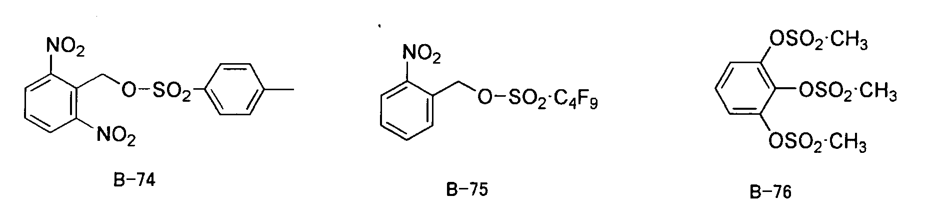

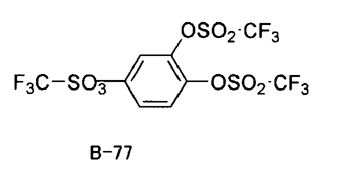

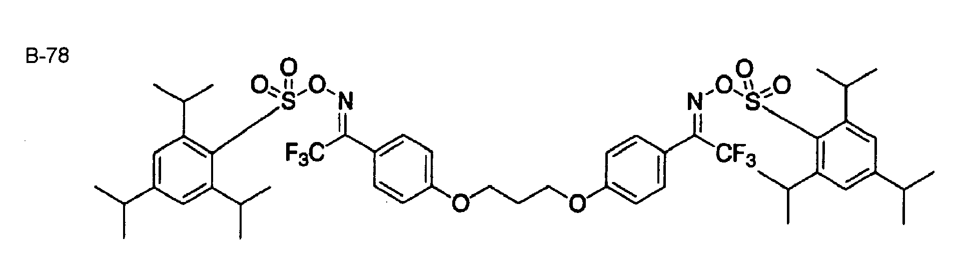

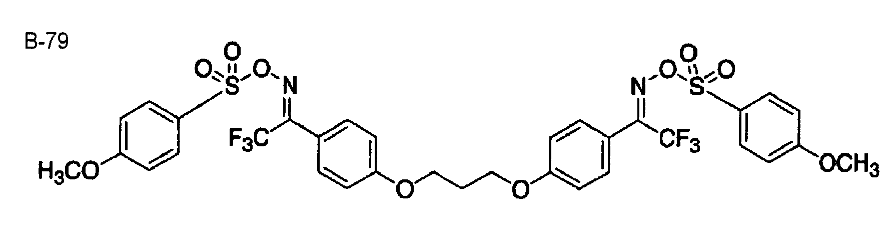

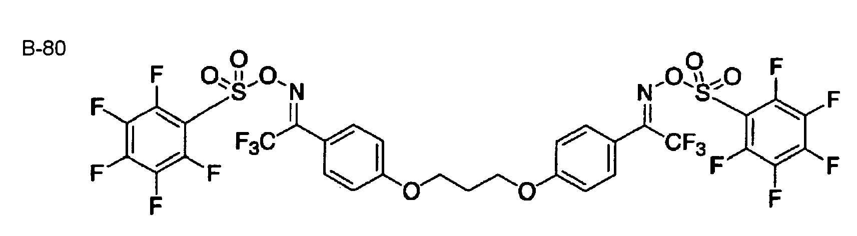

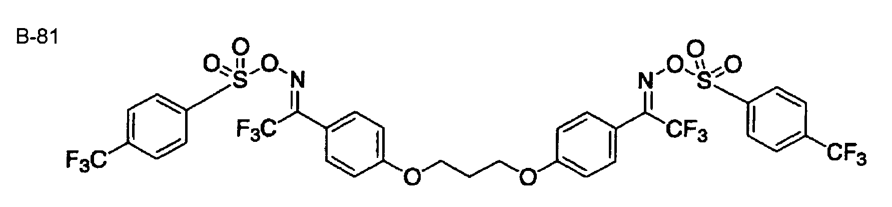

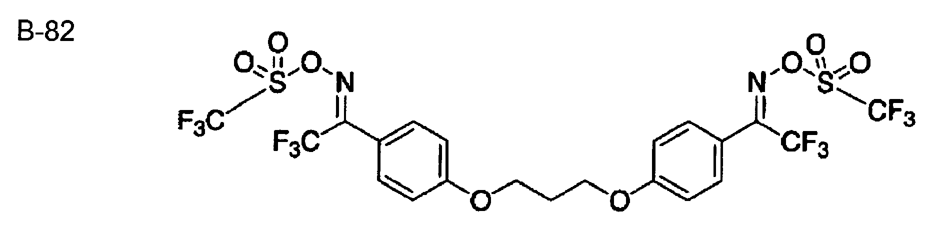

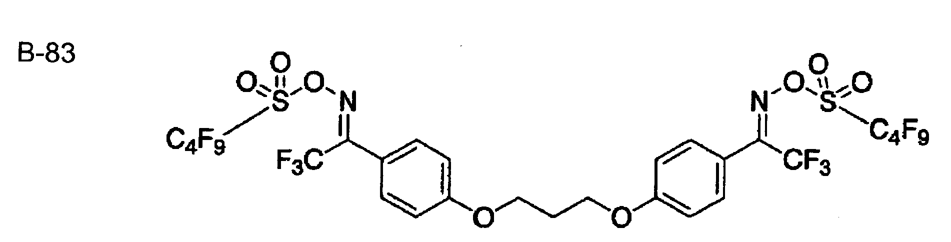

The content of the compound (B) is from 5 to 20 mass%, preferably from 6 to 18 mass%, more preferably from 7 to 16 mass%, based on the entire solid content of the photosensitive composition. The content is 5 mass% or more in view of sensitivity or line edge roughness and 20 mass% or less in view of resolving power, pattern profile and film quality. One of the compound (B) may be used, or two or more species thereof may be mixed and used. For example, a compound capable of generating an arylsulfonic acid upon irradiation with actinic rays or radiation and a compound capable of generating an alkylsulfonic acid upon irradiation with actinic rays or radiation may be used in combination as the compound (B).

The compound (B) can be synthesized by a known method such as synthesis method described in JP-A-2002-27806.

### (Compound (C) capable of generating a carboxylic acid upon irradiation with actinic rays or radiation)

In the positive resist composition of the present invention, a compound capable of generating a carboxylic acid upon irradiation with actinic rays or radiation (sometimes referred to as a "compound (C) " or a "carboxylic acid generator") may be used in combination with the sulfonic acid generator (compound (B)).

The carboxylic acid generator is preferably a compound represented by the following formula (C): 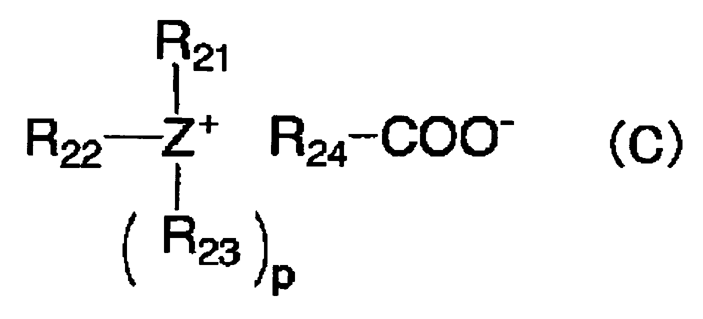 wherein R₂₁ to R₂₃ each independently represents an alkyl group, a cycloalkyl group, an alkenyl group or an aryl group, R₂₄ represents a hydrogen atom, an alkyl group, a cycloalkyl group, an alkenyl group or an aryl group, Z represents a sulfur atom or an iodine atom, and p is 1 when Z is a sulfur atom, and 0 when Z is an iodine atom.

In formula (C), R₂₁ to R₂₃ each independently represents an alkyl group, a cycloalkyl group, an alkenyl group or an aryl group, and these groups each may have a substituent.

Examples of the substituent which the alkyl group, cycloalkyl group and alkenyl group each may have include a halogen atom (e.g., chlorine, bromine, fluorine), an aryl group (e.g., phenyl, naphthyl), a hydroxy group and an alkoxy group (e.g., methoxy, ethoxy, butoxy).

Examples of the substituent which the aryl group may have include a halogen atom (e.g., chlorine, bromine, fluorine), a nitro group, a cyano group, an alkyl group (e.g., methyl, ethyl, tert-butyl, tert-amyl, octyl), a hydroxy group and an alkoxy group (e.g., methoxy, ethoxy, butoxy).

R₂₁ to R₂₃ each is independently preferably an alkyl group having a carbon number of 1 to 12, a cycloalkyl group having a carbon number of 3 to 12, an alkenyl group having a carbon number of 2 to 12 or an aryl group having a carbon number of 6 to 24, more preferably an alkyl group having a carbon number of 1 to 6, a cycloalkyl group having a carbon number of 3 to 6 or an aryl group having a carbon number of 6 to 18, still more preferably an aryl group having a carbon number of 6 to 15, and these groups each may have a substituent.

R₂₄ represents a hydrogen atom, an alkyl group, a cycloalkyl group, an alkenyl group or an aryl group.

Examples of the substituent which the alkyl group, cycloalkyl group and alkenyl group each may have are the same as those of the substituent described above when R₂₁ is an alkyl group. Examples of the substituent for the aryl group are the same as those of the substituent described above when R₂₁ is an aryl group.

R₂₄ is preferably a hydrogen atom, an alkyl group having a carbon number of 1 to 30, a cycloalkyl group having a carbon number of 3 to 30, an alkenyl group having a carbon number of 2 to 30 or an aryl group having a carbon number of 6 to 24, more preferably an alkyl group having a carbon number of 1 to 18, a cycloalkyl group having a carbon number of 3 to 18 or an aryl group having a carbon number of 6 to 18, still more preferably an alkyl group having a carbon number of 1 to 12, a cycloalkyl group having a carbon number of 3 to 12 or an aryl group having a carbon number of 6 to 15. These groups each may have a substituent.

Z represents a sulfur atom or an iodine atom. p is 1 when Z is a sulfur atom, and 0 when Z is an iodine atom.

Incidentally, two or more cation moieties of formula (C) may combine through a single bond or a linking group (e.g., -S-, -O-) to form a cation structure having a plurality of cation moieties of formula (C).

Specific preferred examples of the compound (C) capable of generating a carboxylic acid upon irradiation with actinic rays or radiation are set forth below, but the present invention is of course not limited thereto.

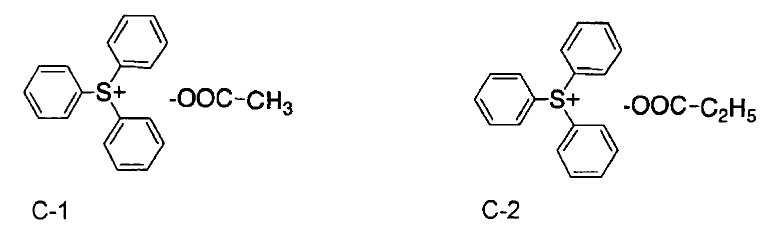

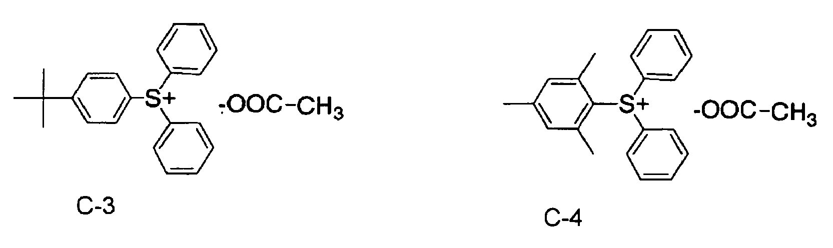

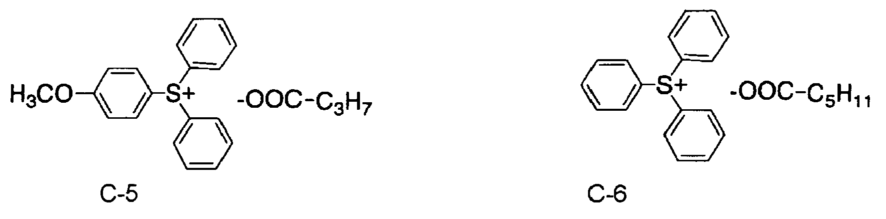

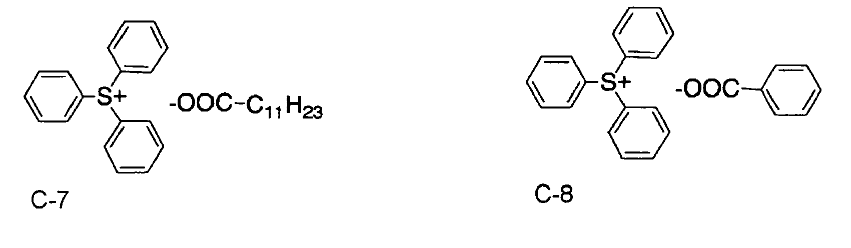

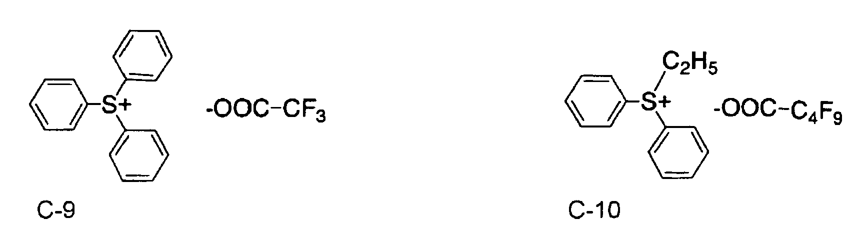

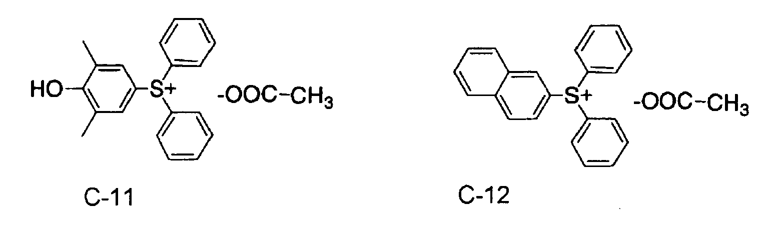

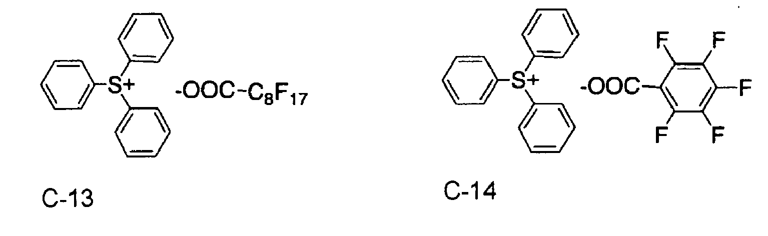

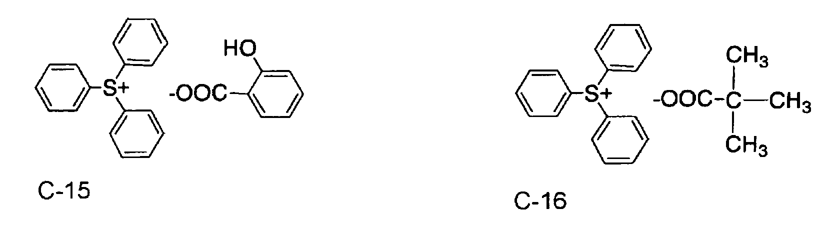

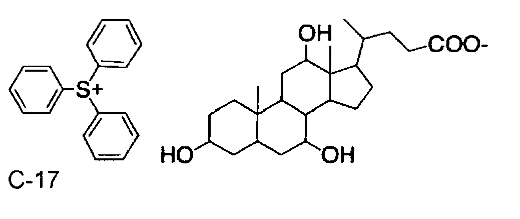

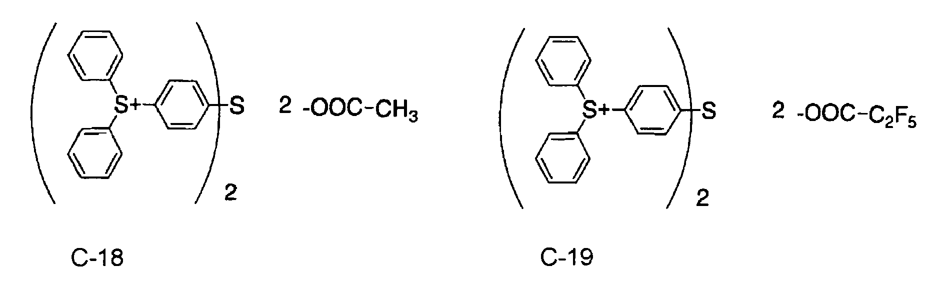

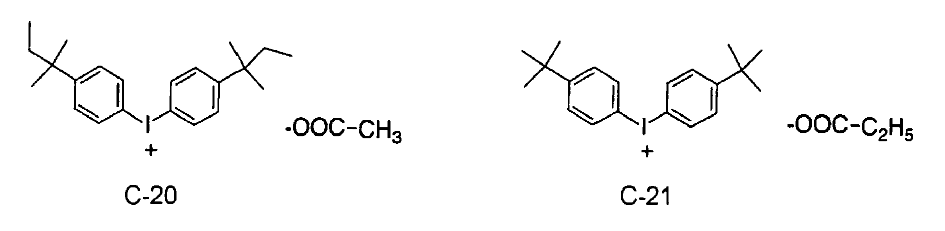

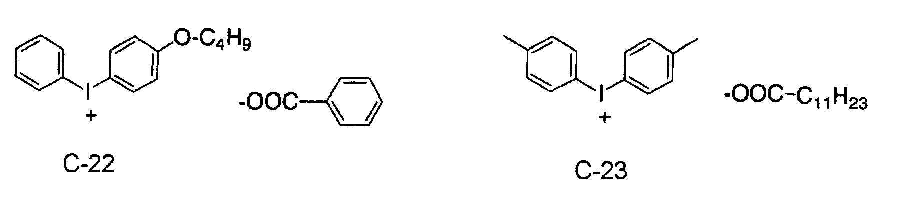

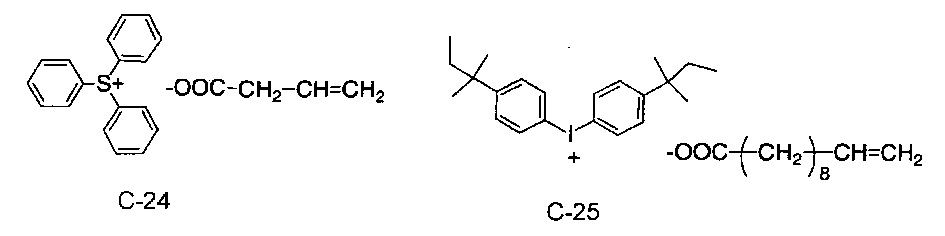

The content of the compound (C) in the positive resist composition of the present invention is preferably from 0.01 to 10 mass%, more preferably from 0.03 to 5 mass%, still more preferably from 0.05 to 3 mass%, based on the entire solid content of the composition. One of these compounds capable of generating a carboxylic acid upon irradiation with actinic rays or radiation may be used, or two or more species thereof may be mixed and used.

The compound (C)/compound (B) (ratio by mass) is usually from 99.9/0.1 to 50/50, preferably from 99/1 to 60/40, more preferably from 98/2 to 70/30.

The compound (C) can be synthesized by a known method such as synthesis method described in JP-A-2002-27806.

### [3] Organic basic compound

In the present invention, an organic basic compound is preferably used from the standpoint of, for example, enhancing the performance (e.g., resolving power) or storage stability. The organic basic compound is more preferably a nitrogen atom-containing compound (nitrogen-containing basic compound).

The organic basic compound preferred in the present invention is a compound having basicity stronger than that of phenol.

The preferred chemical environment thereof includes structures of the following formulae (A) to (E). The structures of formulae (B) to (E) each may form a part of a ring structure.

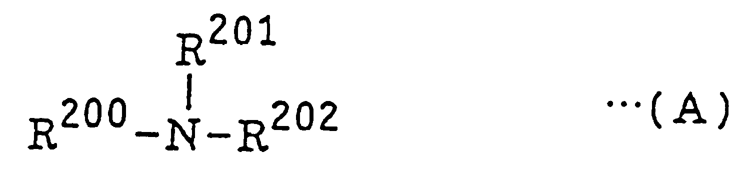

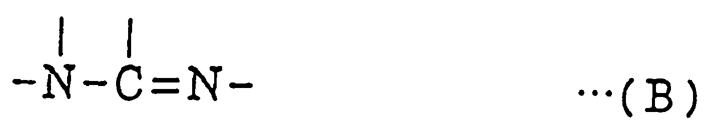

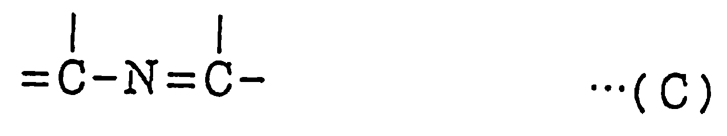

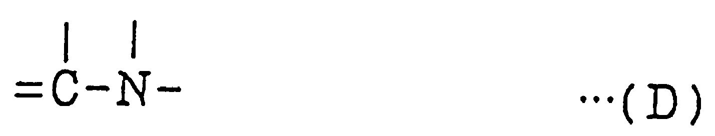

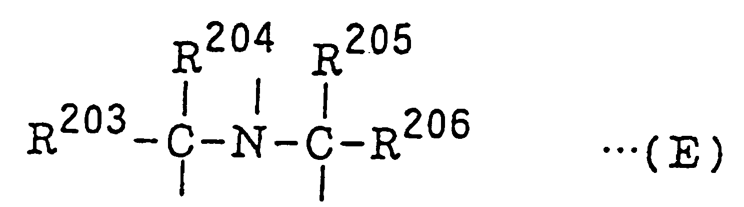

In formula (A), R²⁰⁰, R²⁰¹ and R²⁰², which may be the same or different, each represents a hydrogen atom, an alkyl group or cycloalkyl group having a carbon number of 1 to 20 or an aryl group having a carbon number of 6 to 20, and R²⁰¹ and R²⁰² may combine with each other to form a ring.

The alkyl group, cycloalkyl group and aryl group as R²⁰⁰, R²⁰¹ and R²⁰² each may have a substituent. The alkyl group or cycloalkyl group having a substituent is preferably an aminoalkyl group or aminocycloalkyl group having a carbon number of 1 to 20 or a hydroxyalkyl group having a carbon number of 1 to 20.

In formula (E), R²⁰³, R²⁰⁴, R²⁰⁵ and R²⁰⁶, which may be the same or different, each represents an alkyl group or cycloalkyl group having a carbon number of 1 to 6.

The compound is more preferably a nitrogen-containing basic compound having two or more nitrogen atoms differing in the chemical environment within one molecule, still more preferably a compound containing both a substituted or unsubstituted amino group and a nitrogen-containing ring structure, or a compound having an alkylamino group.

Specific preferred examples thereof include guanidine, aminopyridine, aminoalkylpyridine, aminopyrrolidine, indazole, imidazole, pyrazole, pyrazine, pyrimidine, purine, imidazoline, pyrazoline, piperazine, aminomorpholine and aminoalkylmorpholine. Preferred examples of the substituent which these compounds each may have include an amino group, an alkylamino group, an aminoaryl group, an arylamino group, an alkyl group (particularly, an aminoalkyl group as the substituted alkyl group), an alkoxy group, an acyl group, an acyloxy group, an aryl group, an aryloxy group, a nitro group, a hydroxyl group and a cyano group.

More preferred examples of the compound include, but are not limited to, guanidine, 1,1-dimethylguanidine, 1,1,3,3-tetramethylguanidine, imidazole, 2-methylimidazole, 4-methylimidazole, N-methylimidazole, 2-phenylimidazole, 4,5-diphenylimidazole, 2,4,5-triphenylimidazole, 2-aminopyridine, 3-aminopyridine, 4-aminopyridine, 2-dimethylaminopyridine, 4-dimethylaminopyridine, 2-diethylaminopyridine, 2-(aminomethyl)pyridine, 2-amino-3-methylpyridine, 2-amino-4-methylpyridine, 2-amino-5-methylpyridine, 2-amino-6-methylpyridine, 3-aminoethylpyridine, 4-aminoethylpyridine, 3-aminopyrrolidine, piperazine, N-(2-aminoethyl)piperazine, N-(2-aminoethyl)piperidine, 4-amino-2,2,6,6-tetramethylpiperidine, 4-piperidinopiperidine, 2-iminopiperidine, 1-(2-aminoethyl)pyrrolidine, pyrazole, 3-amino-5-methylpyrazole, 5-amino-3-methyl-1-p-tolylpyrazole, pyrazine, 2-(aminomethyl)-5-methylpyrazine, pyrimidine, 2,4-diaminopyrimidine, 4,6-dihydroxypyrimidine, 2-pyrazoline, 3-pyrazoline, N-aminomorpholine and N-(2-aminoethyl)morpholine.

One of these nitrogen-containing basic compounds is used alone, or two or more species thereof are used in combination.

A tetraalkylammonium salt-type nitrogen-containing basic compound may also be used. Among such compounds, a tetraalkylammonium hydroxide having a carbon number of 1 to 8 (e.g., tetramethylammonium hydroxide, tetraethylammonium hydroxide, tetra-(n-butyl)ammonium hydroxide) is preferred. One of these nitrogen-containing basic compounds is used alone, or two or more species thereof are used in combination.

As for the ratio of the acid generator and the organic basic compound used in the composition, the (total amount of acid generator)/(organic basic compound) (ratio by mol) is preferably from 2.5 to 300. When this molar ratio is 2.5 or more, high sensitivity is obtained, and when the molar ratio is 300 or less, the resist pattern can be prevented from thickening in aging after exposure until heat treatment and the resolving power can be enhanced. The (total amount of acid generator)/(organic basic compound) (ratio by mol) is more preferably from 5.0 to 200, still more preferably from 7.0 to 150.

### [4] Surfactants

In the present invention, surfactants can be used and use thereof is preferred in view of film-forming property, adhesion of pattern, reduction in development defects, and the like.

Specific examples of the surfactant include a nonionic surfactant such as polyoxyethylene alkyl ethers (e.g., polyoxyethylene lauryl ether, polyoxyethylene stearyl ether, polyoxyethylene cetyl ether, polyoxyethylene oleyl ether), polyoxyethylene alkylallyl ethers (e.g., polyoxyethylene octylphenol ether, polyoxyethylene nonylphenol ether), polyoxyethylene polyoxypropylene block copolymers, sorbitan fatty acid esters (e.g., sorbitan monolaurate, sorbitan monopalmitate, sorbitan monostearate, sorbitan monooleate, sorbitan trioleate, sorbitan tristearate) and polyoxyethylene sorbitan fatty acid esters (e.g., polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate); a fluorine-containing surfactant and a silicon-containing surfactant, such as EFtop EF301, EF303, EF352 (produced by Shin-Akita Chemical Co., Ltd.), Megafac F171, F173 (produced by Dainippon Ink & Chemicals, Inc.), Florad FC430, FC431 (produced by Sumitomo 3M Inc.), Asahiguard AG710, Surflon S-382, SC101, SC102, SC103, SC04, SC105 and SC106 (produced by Asahi Glass Co., Ltd.) and Troysol S-366 (produced by Troy Chemical Industries, Inc.); organosiloxane polymer KP-341 (produced by Shin-Etsu Chemical Co. , Ltd.) ; and acrylic acid-based or methacrylic acid-based (co) polymer Polyflow No. 75 and No. 95 (produced by Kyoeisha Yushi Kagaku Kogyo) . The amount of such a surfactant blended is usually 2 parts by mass or less, preferably 1 part by mass or less, per 100 parts by mass of the solid content in the composition of the present invention.

One of these surfactants may be used alone or several species thereof may be added in combination.

As for the surfactant, the composition preferably contains any one species of fluorine- and/or silicon-containing surfactants (a fluorine-containing surfactant, a silicon-containing surfactant or a surfactant containing both a fluorine atom and a silicon atom), or two or more species thereof.

Examples of such surfactants include the surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, JP-A-2002-277862 and U.S. Patents 5,405,720, 5,360,692, 5,529,881, 5,296,330, 5,436,098, 5,576,143, 5,294,511 and 5,824,451. The following commercially available surfactants each may also be used as it is.

Examples of the commercially available surfactant which can be used include a fluorine-containing or silicon-containing surfactant such as EFtop EF301 and EF303 (produced by Shin-Akita Chemical Co., Ltd.), Florad FC430 and 431 (produced by Sumitomo 3M Inc.), Megafac F171, F173, F176, F189 and R08 (produced by Dainippon Ink & Chemicals, Inc.), Surflon S-382, SC101, 102, 103, 104, 105 and 106 (produced by Asahi Glass Co., Ltd.), and Troysol S-366 (produced by Troy Chemical Industries, Inc.). In addition, polysiloxane polymer KP-341 (produced by Shin-Etsu Chemical Co., Ltd.) may also be used as the silicon-containing surfactant.

Other than those known surfactants, a surfactant using a polymer having a fluoro-aliphatic group derived from a fluoro-aliphatic compound produced by a telomerization process (also called a telomer process) or an oligomerization process (also called an oligomer process) may be used. The fluoro-aliphatic compound can be synthesized by the method described in JP-A-2002-90991.

The polymer having a fluoro-aliphatic group is preferably a copolymer of a fluoro-aliphatic group-containing monomer with a (poly(oxyalkylene)) acrylate and/or a (poly(oxyalkylene)) methacrylate, and the polymer may have an irregular distribution or may be a block copolymer. Examples of the poly(oxyalkylene) group include a poly (oxyethylene) group, a poly (oxypropylene) group and a poly (oxybutylene) group. This group may also be a unit having alkylenes differing in the chain length within the same chain, such as block-linked poly(oxyethylene, oxypropylene and oxyethylene) and block-linked poly (oxyethylene and oxypropylene). Furthermore, the copolymer of a fluoro-aliphatic group-containing monomer with a (poly(oxyalkylene)) acrylate (or methacrylate) may be not only a binary copolymer but also a ternary or higher copolymer obtained by simultaneously copolymerizing two or more different fluoro-aliphatic group-containing monomers or two or more different (poly(oxyalkylene)) acrylates (or methacrylates).

Examples thereof include commercially available surfactants such as Megafac F178, F-470, F-473, F-475, F-476 and F-472 (produced by Dainippon Ink & Chemicals, Inc.), and further include a copolymer of an acrylate (or methacrylate) having a C₆F₁₃ group with a (poly-(oxyalkylene)) acrylate (or methacrylate), a copolymer of an acrylate (or methacrylate) having a C₆F₁₃ group with (poly(oxyethylene)) acrylate (or methacrylate) and (poly-(oxypropylene)) acrylate (or methacrylate), a copolymer of an acrylate (or methacrylate) having a C₈F₁₇ group with a (poly(oxyalkylene)) acrylate (or methacrylate), and a copolymer of an acrylate (or methacrylate) having a C₈F₁₇ group with (poly(oxyethylene)) acrylate (or methacrylate) and (poly(oxypropylene)) acrylate (or methacrylate).

The amount of the surfactant used is preferably from 0.0001 to 2 mass%, more preferably from 0.001 to 1 mass%, based on the entire amount of the positive resist composition (excluding the solvent).

### [5] Other components

The positive resist composition of the present invention may further contain, if desired, a dye, a photo-base generator and the like.

### 1. Dye

In the present invention, a dye may be used.

A suitable dye includes an oily dye and a basic dye. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Chemical Industries Co., Ltd.), Crystal Violet (CI42555), Methyl Violet (CI42535), Rhodamine B (CI45170B), Malachite Green (CI42000) and Methylene Blue (CI52015).

### 2. Photo-base generator

Examples of the photo-base generator which can be added to the composition of the present invention include the compounds described in JP-A-4-151156, JP-A-4-162040, JP-A-5-197148, JP-A-5-5995, JP-A-6-194834, JP-A-8-146608, JP-A-10-83079 and European Patent 622,682. Specific examples of the photo-base generator which can be suitably used include 2-nitrobenzyl carbamate, 2,5-dinitrobenzylcyclohexyl carbamate, N-cyclohexyl-4-methylphenylsulfonamide and 1,1-dimethyl-2-phenylethyl-N-isopropyl carbamate. Such a photo-base generator is added for the purpose of improving the resist profile or the like.

### 3. Solvents

The resist composition of the present invention is dissolved in a solvent capable of dissolving respective components described above and then coated on a support. Usually, the concentration is, in terms of the solid content concentration of all resist components, preferably from 2 to 30 mass%, more preferably from 3 to 25 mass%.

Preferred examples of the solvent used here include ethylene dichloride, cyclohexanone, cyclopentanone, 2-heptanone, γ-butyrolactone, methyl ethyl ketone, ethylene glycol monomethyl ether, ethylene glycol monoethyl ether, 2-methoxyethyl acetate, ethylene glycol monoethyl ether acetate, propylene glycol monomethyl ether, propylene glycol monomethyl ether acetate, toluene, ethyl acetate, methyl lactate, ethyl lactate, methyl methoxypropionate, ethyl ethoxypropionate, methyl pyruvate, ethyl pyruvate, propyl pyruvate, N,N-dimethylformamide, dimethylsulfoxide, N-methylpyrrolidone and tetrahydrofuran. One of these solvents is used alone, or several species thereof are mixed and used.

The positive resist composition of the present invention is coated on a substrate to form a thin film. The thickness of this coating film is preferably from 0.05 to 4.0 µm.

In the present invention, a commercially available inorganic or organic antireflection film may be used, if desired. Furthermore, an antireflection film may be used by coating it as an underlayer of the resist.

The antireflection film used as the underlayer of the resist may be either an inorganic film type such as titanium, titanium dioxide, titanium nitride, chromium oxide, carbon and amorphous silicon, or an organic film type comprising a light absorbent and a polymer material. The former requires equipment for the film formation, such as vacuum deposition apparatus, CVD apparatus and sputtering apparatus. Examples of the organic antireflection film include a film comprising a diphenylamine derivative and formaldehyde-modified melamine resin condensate, an alkali-soluble resin and a light absorbent described in JP-B-7-69611 (the term "JP-B" as used herein means an "examined Japanese patent publication"), a reaction product of a maleic anhydride copolymer and a diamine-type light absorbent described in U.S. Patent 5,294,680, a film comprising a resin binder and a methylolmelamine-based heat crosslinking agent described in JP-A-6-118631, an acrylic resin-type antireflection film containing a carboxylic acid group, an epoxy group and a light absorbing group within the same molecule described in JP-A-6-118656, a film comprising methylolmelamine and a benzophenone-based light absorbent described in JP-A-8-87115, and a film obtained by adding a low molecular light absorbent to a polyvinyl alcohol resin described in JP-A-8-179509.

Also, the organic antireflection film may be a commercially available organic antireflection film such as DW-30 Series, DUV-40 Series (produced by Brewer Science, Inc.), AR-2, AR-3 and AR-5 (produced by Shipley Co., Ltd.).

In the production or the like of a precision integrated circuit device, the step of forming a pattern on a resist film is performed by coating the positive resist composition of the present invention on a substrate (for example, a silicon/silicon dioxide-coated substrate, a glass substrate, an ITO substrate or a quartz/chromium oxide-coated substrate) to form a resist film, irradiating thereon actinic rays or radiation such as KrF excimer laser light, electron beam or EUV light, and then subjecting the resist film to heating, development, rinsing and drying, whereby a good resist pattern can be formed.

The alkali developer which can be used in the development is an aqueous solution of an alkali (usually, 0.1 to 20 mass%) such as inorganic alkalis (e.g., sodium hydroxide, potassium hydroxide, sodium carbonate, sodium silicate, sodium metasilicate, aqueous ammonia), primary amines (e.g., ethylamine, n-propylamine), secondary amines (e.g., diethylamine, di-n-butylamine), tertiary amines (e.g., triethylamine, methyldiethylamine), alcohol amines (e.g., dimetylethanolamine, triethanolamine), quaternary ammonium salts (e.g., tetramethylammonium hydroxide, tetraethylammonium hydroxide, choline) and cyclic amines (e.g., pyrrole, piperidine). This aqueous solution of an alkali may be used after adding thereto alcohols such as isopropyl alcohol or a surfactant such as nonionic surfactant in an appropriate amount.

Among these developers, preferred are a quaternary ammonium salt, more preferred are tetramethylammonium hydroxide and choline.

The pH of the alkali developer is usually from 10 to 15.

### (Examples)

The present invention is described in greater detail below by referring to Examples, but the present invention should not be construed as being limited thereto. In the following, Resins A-1 to A-20 correspond to Resins (1) to (20) set forth above.

### (Synthesis Example 1: synthesis of Resin A-1)

Acetoxystyrene, styrene and 2-methyl-2-adamantyl cinnamate were charged at a ratio of 60/20/20 (by mol) and dissolved in tetrahydrofuran to prepare 100 mL of a solution having a solid content concentration of 20 mass%. Subsequently, 2 mol% of polymerization initiator V-65 (produced by Wako Pure Chemical Industries, Ltd.) was added thereto and the resulting solution was added dropwise to 10 ml of tetrahydrofuran heated at 60°C, over 4 hours in a nitrogen atmosphere. After the completion of dropwise addition, the reaction solution was heated for 4 hours, and 1 mol% of V-65 was again added, followed by stirring for 4 hours. After the completion of reaction, the reaction solution was cooled to room temperature and then crystallized in 3 L of hexane, and the precipitated white powder was collected by filtration.

The compositional ratio of the polymer determined from C¹³NMR was 58/20/22 (by mol). Also, the weight average molecular weight determined from GPC was 9,500 in terms of the standard polystyrene.

This polymer was dissolved in 100 ml of acetone, 5 ml of hydrochloric acid was then added thereto and after stirring 1 hour, distilled water was added to precipitate a polymer. The precipitate was washed with distilled water and dried under reduced pressure. Furthermore, the polymer was dissolved in 100 ml of ethyl acetate and after adding hexane, the polymer precipitated was dried under reduced pressure to obtain a powder form of the polymer. The weight average molecular weight of this powder determined by GPC was 10,000 in terms of the standard polystyrene.

The resins shown in Table 1, having structures set forth above, were synthesized in the same manner as in Synthesis Example 1. In Table 1, the molar ratio of repeating units is a molar ratio of repeating units starting from the left in the structure shown above.

**Table 1**

| Polymer | Repeating Unit (mol%) | Weight Average Molecular Weight | Dispersity |
|---|---|---|---|
| A-1 | 60/20/20 | 10000 | 1.75 |
| A-2 | 60/25/15 | 8500 | 1.73 |
| A-3 | 60/20/20 | 9500 | 1.64 |
| A-4 | 60/25/15 | 10000 | 1.65 |
| A-5 | 60/25/15 | 9500 | 1.80 |
| A-6 | 60/20/20 | 10500 | 1.65 |
| A-7 | 60/25/15 | 9500 | 1.78 |
| A-8 | 60/20/20 | 10000 | 1.70 |
| A-9 | 60/20/20 | 8500 | 1.85 |
| A-10 | 60/25/15 | 8500 | 1.92 |
| A-11 | 60/20/20 | 12000 | 1.74 |
| A-12 | 60/25/15 | 9000 | 1.55 |
| A-13 | 65/10/25 | 7900 | 1.52 |
| A-14 | 60/20/20 | 11500 | 1.42 |
| A-20 | 70/20/10 | 9000 | 1.29 |
| C-1 | 60/20/20 | 10000 | 2.28 |

Incidentally, Resin C-1 of Comparative Example is a p-hydroxystyrene-styrene-tert-butyl acrylate copolymer (molar ratio: 60/20/20) having a weight average molecular weight of 10,000 and a dispersity of 2.28.

The sulfonic acid generators and carboxylic acid generators used in Examples all were synthesized by a known synthesis method such as synthesis method described in JP-A-2002-27806.

### (Example 1)

### (1) Preparation and Coating of Positive Resist

| | |
|---|---|
| Resin A-2 | 0.93 g |
| Sulfonic Acid Generator B-2 | 0.065 g |
| Carboxylic Acid Generator C-2 | 0.005 g |

These components were dissolved in 8.8 g of propylene glycol monomethyl ether acetate, and 0.003 g of D-1 (see below) as the organic basic compound and 0.001 g of Megafac F176 (produced by Dainippon Ink & Chemicals, Inc., hereinafter simply referred to as "W-1") as the surfactant were further added thereto and dissolved. The obtained solution was microfiltered through a membrane filter having a pore size of 0.1 µm to obtain a resist solution.

This resist solution was coated on a 6-inch silicon wafer by using a spin coater, Mark 8, manufactured by Tokyo Electron Ltd. and then baked at 110°C for 90 seconds to obtain a uniform film having a thickness of 0.25 µm.

### (2) Production of Positive Resist Pattern

This resist film was then irradiated with electron beams by using an electron beam image-drawing apparatus (HL750, manufactured by Hitachi Ltd., accelerating voltage: 50 KeV). After the irradiation, the resist film was baked at 110°C for 90 seconds, dipped in an aqueous 2.38 mass% tetramethylammonium hydroxide (TMAH) solution for 60 seconds, rinsed with water for 30 seconds and then dried. The obtained pattern was evaluated by the following methods.

### (2-1) Sensitivity

The cross-sectional profile of the pattern obtained was observed by using a scanning electron microscope (S-4300, manufactured by Hitachi, Ltd.). The minimum irradiation energy for resolving a 0.15-µm line (line:space = 1:1) was defined as the sensitivity.

### (2-2) Resolving Power

The limiting resolving power (the line and space were separated and resolved) at the irradiation dose of giving the above-described sensitivity was defined as the resolving power. (2-3) Pattern Profile

The cross-sectional profile of a 0.15-µm line pattern at the irradiation dose of giving the above-described sensitivity was observed by using a scanning electron microscope (S-4300, manufactured by Hitachi, Ltd.) and evaluated on a three-stage scale of rectangular, slightly tapered, and tapered.

### (2-4) Defocus Latitude Depended on Line Pitch

In a 0.15-µm line pattern at the irradiation dose of giving the above-described sensitivity, the line width of a dense pattern (line:space = 1:1) and the line width of an isolated pattern were measured. The difference therebetween was defined as the defocus latitude depended on line pitch.

The results of Example 1 were very good, that is, the sensitivity was 8.5 µC/cm², the resolving power was 0.10 µm, the pattern profile was rectangular and the defocus latitude depended on line pitch was 12 nm.

### (Examples 2 to 12 and Comparative Example 1)

Using the compounds shown in Table 2, the preparation and coating of resist and the evaluation of electron beam exposure were performed thoroughly in the same manner as in Example 1. The evaluation results are shown in Table 2.

The component (c) and other component used in Examples and the resin used in Comparative Example are as follows.

### (Organic Basic Compound)

- D-1:: tri-n-hexylamine
- D-2:: 2,4,6-triphenylimidazole
- D-3:: tetra-(n-butyl)ammonium hydroxide (Other Component (Surfactant))
- W-1 :: a fluorine-containing surfactant, Megafac F-176 (produced by Dainippon Ink & Chemicals, Inc.)
- W-2:: a fluorine/silicon-containing surfactant, Megafac R08 (produced by Dainippon Ink & Chemicals, Inc.)
- W-3:: a silicon-containing surfactant, polysiloxane polymer KP-341 (produced by Shin-Etsu Chemical Co., Ltd.)

**Table 2**

| | Composition | | | | | Evaluation | | | |
|---|---|---|---|---|---|---|---|---|---|
| | Resin | Sulfonic Acid Generator | Carboxylic Acid Generator | Basic Compound (0.003 g) | Other Component (0.001 g) | Sensitivity (µC/cm²) | Resolving Power (µm) | Pattern Profile | Defocus Latitude Depended on Line Pitch (nm) |
| Example 1 | A-1 | B-2 (0.065 g) | | D-1 | W-1 | 8.5 | 0.10 | rectangular | 12 |
| Example 2 | A-3 | B-4 (0.07 g) | C-4 (0.005 g) | D-1 | W-1 | 9.5 | 0.10 | rectangular | 10 |
| Example 3 | A-7 | B-2 (0.07 g) | C-7 (0.003 g) | D-2 | W-1 | 10.0 | 0.10 | rectangular | 14 |
| Example 4 | A-8 | B-19 (0.06 g) | | D-2 | W-1 | 8.5 | 0.09 | rectangular | 10 |
| Example 5 | A-9 | B-16 (0.07 g) | C-13 (0.0059 g) | D-2 | W-1 | 10.5 | 0.09 | rectangular | 12 |
| Example 6 | A-10 | B-17 (0.07 g) | C-14 (0.0049 g) | D-2 | W-2 | 9.5 | 0.10 | slightly tapered | 12 |
| Example 7 | A-13 | B-19 (0.06 g) | | D-2 | W-2 | 10.5 | 0.09 | rectangular | 10 |
| Example 8 | A-6 | B-22 (0.079 g) | C-1 (0.003 g) | D-2 | W-2 | 9.5 | 0.09 | rectangular | 12 |
| Example 9 | A-8 | B-18 (0.05 g) | C-2 (0.001 g) | D-2 | W-2 | 9.5 | 0.09 | rectangular | 12 |
| Example 10 | A-2 | B-41 (0.07 g) | C-17 (0.006 g) | D-3 | W-2 | 10.5 | 0.10 | rectangular | 13 |
| Example 11 | A-12 | B-57 (0.07 g) | | D-3 | W-3 | 8.5 | 0.10 | rectangular | 15 |
| Example 12 | A-13 | B-70 (0.06 g) | C-22 (0.002 g) | D-3 | W-1 | 10.5 | 0.10 | slightly tapered | 12 |
| Comparative Example 1 | C-1 | B-2 (0.065 g) | C-2 (0.005 g) | D-1 | W-1 | 13.5 | 0.15 | tapered | 35 |

It is seen from Table 2 that in the pattern formation by the irradiation with electron beams, the positive resist composition of the present invention exhibits high sensitivity and high resolving power and is excellent in the pattern profile and defocus latitude depended on line pitch, as compared with the compound of Comparative Example.

### (Example 14)

The preparation and coating of a resist shown in Table 3 were performed thoroughly in the same manner as in Example 1 to obtain a resist film. However, the film thickness was changed to 0.40 µm.

### (3) Formation of Positive Pattern

The resist film obtained was pattern-exposed by using a KrF excimer laser stepper (FPA-3000EX-5, manufactured by Canon Inc., wavelength: 248 nm). The processing after the exposure was performed in the same manner as in Example 1. The evaluation of the pattern was performed as follows.

### (3-1) Sensitivity

The cross-sectional profile of the pattern obtained was observed by using a scanning electron microscope (S-4300, manufactured by Hitachi, Ltd.). The minimum irradiation energy for resolving a 0.18-µm line (line:space = 1:1) was defined as the sensitivity.

### (3-2) Resolving Power

The limiting resolving power (the line and space were separated and resolved) at the irradiation dose of giving the above-described sensitivity was defined as the resolving power.

### (3-3) Pattern Profile

The cross-sectional profile of a 0.18-µm line pattern at the irradiation dose of giving the above-described sensitivity was observed by using a scanning electron microscope (S-4300, manufactured by Hitachi, Ltd.) and evaluated on a three-stage scale of rectangular, slightly tapered, and tapered.

### (3-4) Defocus Latitude Depended on Line Pitch

In a 0.18-µm line pattern at the irradiation dose of giving the above-described sensitivity, the line width of a dense pattern (line:space = 1:1) and the line width of an isolated pattern were measured. The difference therebetween was defined as the defocus latitude depended on line pitch.

The results of Example 14 were very good, that is, the sensitivity was 34 mJ/cm², the resolving power was 0. 14 µm, the pattern profile was rectangular and the defocus latitude depended on line pitch was 10 nm.

### (Examples 15 to 20 and Comparative Example 2)

Using the compounds shown in Table 3, the preparation and coating of resist and the evaluation of KrF excimer laser exposure were performed thoroughly in the same manner as in Example 14. The evaluation results are shown in Table 3.

**Table 3**

| | Composition | | | | | Evaluation | | | |
|---|---|---|---|---|---|---|---|---|---|
| | Resin | Sulfonic Acid Generator | Carboxylic Acid Generator | Basic Compound (0.003 g) | Other Component (0.001 g) | Sensitivity (mJ/cm²) | Resolving Power (µm) | Pattern Profile | Defocus Latitude Depended on Line Pitch (nm) |
| Example 14 | A-1 | B-2 (0.065 g) | C-2 (0.005 g) | D-1 | W-1 | 34 | 0.14 | rectangular | 10 |
| Example 15 | A-3 | B-5 (0.07 g) | C-3 (0.003 g) | D-1 | W-2 | 35 | 0.14 | rectangular | 12 |
| Example 16 | A-8 | B-7 (0.07 g) | C-8 (0.004 g) | D-2 | W-1 | 35 | 0.14 | rectangular | 10 |
| Example 17 | A-9 | B-20 (0.05 g) | C-1 (0.003 g) | D-2 | W-2 | 30 | 0.15 | rectangular | 8 |
| Example 18 | A-5 | B-57 (0.06 g) | C-13 (0.003 g) | D-1 | W-1 | 31 | 0.15 | rectangular | 11 |
| Example 19 | A-12 | B-71 (0.06 g) | C-14 (0.003 g) | D-1 | W-1 | 33 | 0.14 | rectangular | 9 |
| Example 20 | A-20 | B-80 (0.07 g) | C-20 (0.002 g) | D-3 | W-3 | 32 | 0.15 | rectangular | 10 |
| Comparative Example 2 | C-1 | B-2 (0.065 g) | C-2 (0.005 g) | D-1 | W-1 | 38 | 0.17 | tapered | 18 |

It is seen from Table 3 that also in the pattern formation by the exposure to a KrF excimer laser, the positive resist composition of the present invention exhibits high sensitivity and high resolving power and is excellent in the pattern profile and defocus latitude depended on line pitch, as compared with the compound of Comparative Example.

### (Examples 21 to 23 and Comparative Example 3)

Using each resist composition shown in Table 4, a resist film was obtained in the same manner as in Example 1. However, the resist film thickness was changed to 0.13 µm. The resist film obtained was subjected to surface exposure by using EUV light (wavelength: 13 nm) while changing the exposure dose in steps of 0.5 mJ in the range from 0 to 5.0 mJ and then baked at 110°C for 90 seconds. Thereafter, the dissolution rate at each exposure dose was measured by using an aqueous 2.38 mass% tetramethylammonium hydroxide (TMAH) solution to obtain a sensitivity curve. The exposure dose when the dissolution rate of the resist was saturated in this sensitivity curve was defined as the sensitivity and also, the dissolution contrast (γ value) was calculated from the gradient in the straight line part of the sensitivity curve. As the γ value is larger, the dissolution contrast is more excellent.

The results are shown in Table 4.

**Table 4**

| | Composition | | | | | Evaluation | |
|---|---|---|---|---|---|---|---|
| | Resin | Sulfonic Acid Generator | Carboxylic Acid Generator | Basic Compound (0.003 g) | Other Component (0.001 g) | Sensitivity (MJ/cm²) | γ value |
| Example 21 | A-10 | B-2 (0.065 g) | C-2 (0.005 g) | D-1 | W-1 | 2.5 | 8.5 |
| Example 22 | A-3 | B-3 (0.07 g) | C-4 (0.005 g) | D-3 | W-1 | 3.0 | 9.5 |
| Example 23 | A-7 | B-4 (0.07 g) | C-7 (0.004 g) | D-2 | W-1 | 2.5 | 9.0 |
| Comparative Example 3 | C-1 | B-2 (0.065 g) | | D-1 | W-1 | 3.0 | 5.0 |

It is seen from Table 4 that in the characteristic evaluation by the irradiation with EUV light, the positive resist composition of the present invention exhibits high sensitivity and high contrast and is excellent, as compared with the composition of Comparative Example.

The present application claims foreign priority based on Japanese Patent Application (JP 2005-285022) filed September 29 of 2005, the contents of which is incorporated herein by reference.

## Claims

1. A positive resist composition comprising:
(A-1) a resin of which a solubility in an alkali developer increases under the action of an acid, the resin comprising a repeating unit represented by formula (Ia) and a repeating unit represented by formula (A1); and
(B) a compound capable of generating an acid upon irradiation with one of actinic rays and radiation: 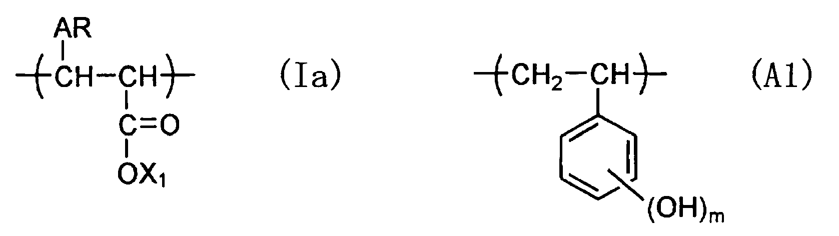 wherein
in the formula (Ia), AR represents an aromatic group, and X₁ represents a group having a carbon number of 5 or more and being capable of decomposing under the action of an acid, and
in the formula (A1), m represents an integer of one of 1 and 2.

2. The positive resist composition as claimed in claim 1, wherein X₁ has a tertiary carbon atom bonded to the oxygen atom in formula (Ia).

3. The positive resist composition as claimed in claim 1, wherein X₁ has an alicyclic group.

4. A positive resist composition comprising:
(A-2) a resin of which a solubility in an alkali developer increases under the action of an acid, the resin comprising a repeating unit represented by formula (Ib) and a repeating unit represented by formula (A2); and
(B) a compound capable of generating an acid upon irradiation with one of actinic rays and radiation: 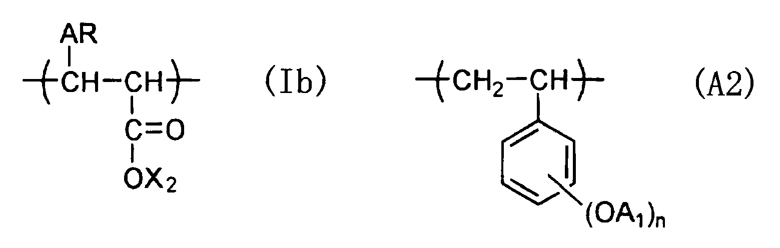 wherein
in the formula (Ib), AR represents an aromatic group and X₂ represents one of a hydrogen atom and a hydrocarbon group, and
in the formula (A2), A₁ represents a group containing a group capable of decomposing under the action of the acid, and n represents an integer of one of 1 and 2.

5. The positive resist composition as claimed in claim 4, wherein X₂ is a group capable of decomposing under the action of the acid.

6. The positive resist composition as claimed in claim 5, wherein X₂ is a group having an alicyclic group and being capable of decomposing under the action of the acid.

7. A pattern forming method comprising:
forming a resist film from a positive resist composition claimed in claim 1; and
exposing and developing the resist film.

8. The pattern forming method as claimed in claim 7, wherein the resist film is exposed with one of electron beam and extreme ultraviolet light.

9. A pattern forming method comprising:
forming a resist film from a positive resist composition claimed in claim 4; and
exposing and developing the resist film.

10. The pattern forming method as claimed in claim 9, wherein the resist film is exposed with one of electron beam and extreme ultraviolet light.
